(19) Europäisches Patentamt
European Patent Office
Office européen des brevets

(11) **EP 4 236 072 B1**

(12) **EUROPÄISCHE PATENTSCHRIFT**

(45) Veröffentlichungstag und Bekanntmachung des Hinweises auf die Patenterteilung:
**29.04.2026   Patentblatt 2026/18**

(21) Anmeldenummer: **23185803.6**

(22) Anmeldetag: **18.03.2021**

(51) Internationale Patentklassifikation (IPC):
*H10D 89/60* (2025.01)   *H02H 9/04* (2006.01)
*H03K 17/16* (2006.01)   *H01L 23/60* (2006.01)
*G01R 31/26* (2020.01)

(52) Gemeinsame Patentklassifikation (CPC):
**H10D 89/601; G01R 31/2648; H03K 17/162;**
H10W 42/60; H10W 90/756

(54) **VORRICHTUNG UND VERFAHREN ZUR VERHINDERUNG EINES SUBSTRATSTROMS IN EINEM IC-HALBLEITERSUBSTRAT**

APPARATUS AND METHOD FOR PREVENTING SUBSTRATE CURRENT IN IC SEMICONDUCTOR SUBSTRATE

APPAREIL ET PROCÉDÉ POUR EMPÊCHER UN COURANT DE SUBSTRAT DANS UN SUBSTRAT SEMI-CONDUCTEUR DE CIRCUIT INTÉGRÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität:  **18.03.2020   DE 102020107479**

(43) Veröffentlichungstag der Anmeldung:
**30.08.2023   Patentblatt 2023/35**

(62) Dokumentnummer(n) der früheren Anmeldung(en) nach Art. 76 EPÜ:
**21714114.2 / 4 122 012**

(73) Patentinhaber:
• **Elmos Semiconductor SE**
**51379 Leverkusen (DE)**
• **Hyundai Mobis Co., Ltd.**
**Gangnam-gu**
**Seoul (KR)**

(72) Erfinder:
• **Abaza, Fikret**
**44227 Dortmund (DE)**
• **Sudhaus, Andre**
**44227 Dortmund (DE)**
• **Friemann, Uwe**
**44227 Dortmund (DE)**
• **Friesen, Andreas**
**44227 Dortmund (DE)**
• **Schmalhorst, Mats**
**44227 Dortmund (DE)**
• **Liedtke, Marco**
**44227 Dortmund (DE)**

(74) Vertreter: **dompatent**
**Partnerschaft von**
**Patentanwälten und Rechtsanwälten mbB**
**Deichmannhaus am Dom**
**Bahnhofsvorplatz 1**
**50667 Köln (DE)**

(56) Entgegenhaltungen:
EP-A1- 0 847 089       WO-A1-2010/095003
US-A1- 2005 110 111    US-A1- 2008 023 768
US-A1- 2012 176 161

**Beschreibung**

Die Erfindung richtet sich auf verschiedene Vorrichtungen und Verfahren zur Verhinderung der Injektion eines Substratstroms in das Substrat Sub eines CMOS-Schaltkreises.

Die Erfindung eignet sich vornehmlich zur Verbesserung der Zuverlässigkeit der ordnungsgemäßen Funktion von Airbag-Zündkreisen, die typischerweise als integrierte Schaltungen ausgeführt sind. Beispiele für derartige Airbag-Schaltungen sind in DE-A-44 32 301, DE-T-60 2004 006 973 und DE-B-10 2005 048 239 beschrieben.

Zum Stand der Technik zählen ferner Schaltungen gemäß US-A-2012/0176161 und US-A-2005/0110111.

Im unmittelbaren zeitlichen Umfeld der Entstehung dieser Erfindung wurden verschiedene Produktrückrufe von Automobilherstellern bekannt, bei denen durch Vorrichtungen gemäß dem zum Zeitpunkt der Anmeldung bekannten Standes der Technik Airbags nicht öffneten.

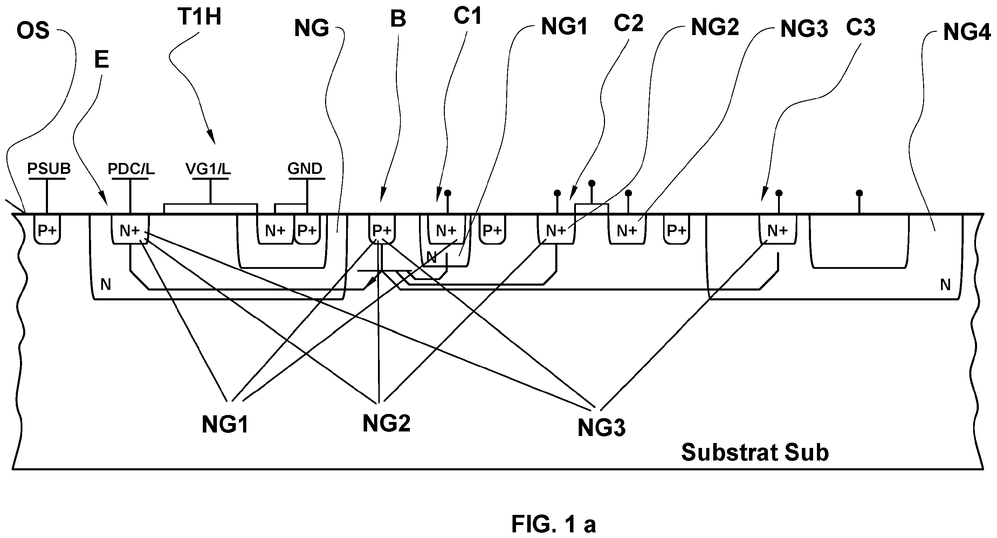

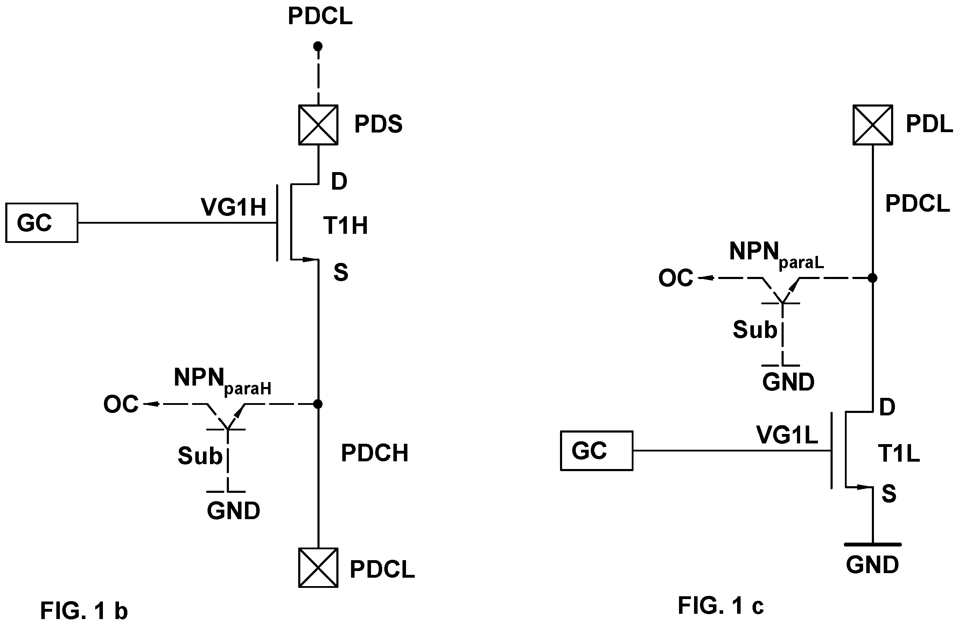

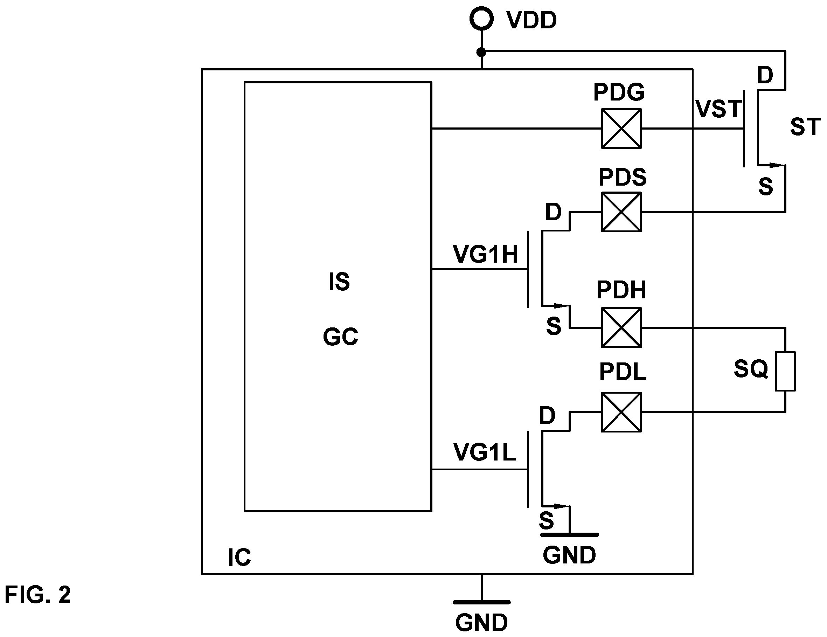

Hierdurch wurden neue bis dahin unbekannte Anforderungen an solche Sicherheitseinrichtungen durch die betroffenen Automobilhersteller ermittelt und an die Lieferanten weitergegeben. Untersuchungen haben ergeben, dass Probleme an den nach außen geführten Anschlüssen von CMOS-Schaltungen auftreten können. Diese Anschlüsse des ICs sind typischerweise über Bonddrähte mit den Leitern eines Lead Frame verbunden, der die nach außen geführten Außenanschlusskontakte des gehäusten IC-Bauteils aufweist. Wenn ein solcher Anschluss der CMOS-Schaltung beispielsweise durch einen Kurzschluss in einer an den zugehörigen Außenanschlusskontakt des IC angeschlossenen, im Fahrzeug verlegten Leitung mit Masse oder einem anderen Potenzial oder durch Folgeeffekte auf Grund parasitärer Induktivitäten und Kapazitäten der Leitungen und Anschlüsse mit insbesondere einem stark negativen Potenzial belastet werden, das unterhalb des Potenzials des Halbleitersubstrats liegt, in dem die CMOS-Schaltung integriert ist. Dann nämlich kann ein lateraler parasitärer bipolarer NPN-Transistor entstehen, und zwar in Kombination mit elektronischen Bauteilen oder deren Komponenten, die benachbart zu demjenigen elektronischen Bauteil angeordnet sind, das mit einem fehlerhafterweise "unter Substratpotenzial" liegenden Außenanschluss verbunden ist, wie anhand von Fig. 1a (und den Fign. 1b sowie 1c und Fig. 2) nachfolgend verdeutlicht wird.

In Fig. 1a ist ein Querschnitt durch ein p-dotiertes Substrat Sub gezeigt, in dessen Oberseite OS mehrere n-dotierte N-Gebiete NG, NG1, NG2, NG3 und NG4 eingebracht sind. In dem N-Gebiet NG ist in diesem Ausführungsbeispiel ein MOS-Transistor ausgebildet, der beispielsweise als High-Side-Transistor T1H oder als Low-Side-Transistor T1L Teil einer Schaltung beispielsweise eines Airbag-Zündkreises sein kann. Mit dem N-Gebiet NG1 ist beispielsweise eine Schutzringstruktur gekennzeichnet. Außerhalb dieses Schutzringes befindet sich in diesem Beispielfall ein weiterer MOS-Transistor, der zwei starke n-dotierte Anschlussgebiete NG2 und NG3 für Source und Drain aufweist. Rechts in Fig. 1a ist ein weiteres N-Gebiet NG4 beispielhaft gezeigt. Das Substrat Sub ist an mehreren Stellen auf ein Substratpotenzial PSUB gelegt.

In dem Beispiel der Fig. 1a können mindestens drei derartige parasitäre bipolare NPN-Transistoren NPN1, NPN2 und NPN3 oder, allgemeiner formuliert, parasitäre laterale bipolare NPN- oder PNP-Strukturen entstehen. Dabei ist die Basis B jedes NPN-Transistors durch das p-Substrat Sub im Bereich zwischen den n-Gebieten NG und NG1 gebildet, während der Emitter E durch den Anschluss PDCL repräsentiert wird. Die Kollektoren C1, C2, C3 der drei Transistoren werden durch die N-Gebiete NG1, NG2 (alternativ oder zusätzlich auch NG3) und NG3 gebildet.

Wenn nun während des Betriebs der Schaltung, zu der der MOS-Transistor T1H bzw. T1L gehört, das Potenzial am Anschluss PDCL, also am Drain-Anschluss eines Low-Side-Transistors T1L oder am Source-Anschluss eines High-Side-Transistors T1H unter das Substratpotenzial PSUB fällt, was durch typischerweise nicht vorhersehbare Ereignisse wie beispielsweise einen Kurzschluss geschehen kann, so beginnt mindestens einer der beispielhaft gezeigten drei parasitären NPN-Transistoren NPN1, NPN2 oder NPN3 zu leiten, so dass ein Strom in dem Emitter fließt, der durch den Anschluss PDCL repräsentiert ist. Dieser Strom gelangt zu den gezeigten Anschlüssen der anderen N-Gebiete bzw. der Komponenten dieser N-Gebiete, die jeweils den Kollektor des jeweiligen NPN-Transistors NPN1, NPN2 und NPN3 bilden. Das wiederum kann zu Fehlfunktionen dieser anderen elektronischen Bauteile führen.

Fig. 1b zeigt eine schematisch vereinfachte Situation für einen High-Side-Ausgangstransistor T1H, dessen Aufgabe es ist, den ihm zugeordneten Außenanschlusskontakt PDH, bei den es sich um einen Außenanschluss des IC handelt, über den weiteren Außenanschlusskontakt PDS mit dem positiven Versorgungspotenzial VDD zu verbinden. Typischerweise ist noch ein Sicherheitstransistor ST zwischen die positives Versorgungspotenzial VDD führende Leitung und den High-Side-Ausgangstransistor T1H geschaltet (siehe Fig. 2). In Airbag-Schaltkreisen handelt es sich bei der positives Versorgungspotenzial VDD führenden Leitung typischerweise, aber nicht notwendigerweise, um den positiven Pol der Energiereserve. Zur Vereinfachung ist der Sicherheitstransistor ST in Fig. 1b nicht eingezeichnet. Der High-Side-Ausgangstransistor T1H kann von einer ESD-Schutzschaltung typischerweise über die Steuerelektrode VG1H des High-Side-Ausgangstransistors T1H eingeschaltet werden, was grundsätzlich bekannt ist. Des Weiteren kann eine Funktionsschaltung GC (hierbei handelt es sich z.B. um die Schaltung zum Auslösen eines Airbags im Falle eines Crashs) den High-Side-Ausgangstransistor T1H einschalten und ausschalten, wobei die ESD-Schutzschaltung typischerweise die Funktionsschaltung GC "überschreiben" kann. Andere Realisierungen der ESD-Schutzschaltung sind möglich. Das Problem tritt auf, wenn am Außenanschlusskontakt PDH des High-Side-Ausgangstransistors T1H ein größerer Strom entnommen wird. Dies kann z.B. dann auftreten, wenn infolge eines Unfalls wie oben beschrieben der Außenanschlusskontakt PDH mit einem erheblich niedrigeren, nicht den vorgesehenen Betriebssituationen entsprechenden Potenzial belastet wird. Die Gründe hierfür sollen hier nicht näher diskutiert werden, da sie für das Verständnis der Erfindung unerheblich sind.

Der High-Side-Transistor T1H ist typischerweise in einer n-dotierte Wanne des Substrats Sub ausgebildet (siehe Fig. 1a). Das Substrat Sub eines CMOS-Schaltkreises ist bevorzugt p-dotiert. Selbstverständlich können die Polaritäten der Ladungsträger vertauscht sein, was zwar unüblich aber technisch realisierbar ist (und auch für das Beispiel gemäß Fig. 1a gilt). Obwohl im Folgenden also von einem p-dotierten Substrat ausgegangen wird, bezieht sich daher die Erfindung ausdrücklich auch auf CMOS-Schaltungen mit einem n-dotierten Substrat.

Es sei nun angenommen, dass eine n-Wanne mit dem Außenanschlusskontakt PDH verbunden ist. Bei der n-Wanne kann es sich beispielsweise um die Konstruktion einer ESD-Schutzstruktur handeln. Für die Erfindung ist die exakte Natur der n-Wanne ohne Belang, da hier nur die Bildung eines parasitären NPN-Transistors $NPN_{paraL}$, $NPN_{paraH}$ relevant ist. Wird also an dem Außenanschlusskontakt PDH ein größerer Strom entnommen, so führt dies zu einem Stromfluss aus der n-Wanne und damit zu einer Öffnung der unvermeidbaren, parasitären PN-Diode zwischen der n-Wanne und dem Substrat Sub, wenn der Potenzialunterschied zwischen dem Potenzial PSUB des Substrats Sub minus dem Potenzial der n-Wanne negativ wird und die negative Schleusenspannung dieser PN-Diode unterschritten wird. Typischerweise liegt bei modernen CMOS-Schaltkreisen das Substrat auf dem Bezugspotenzial GND (nachfolgend mitunter auch mit Bezugspotenzialleitung GND bezeichnet), was in den Figuren gestrichelt angedeutet ist und bei dem es sich typischerweise um Masse handelt. Da die CMOS-Schaltung eine Vielzahl von n-Wannen oder allgemeiner formuliert eine Vielzahl von n-dotierten Gebieten in dem Substrat als Vorrichtungsteile anderer Schaltungsteile OC der Schaltung auf Potenzialen oberhalb des Substratpotenzials umfasst, wird nun über die Substratkontakte der CMOS-Schaltung der entnommene Strom nachgeliefert, so dass sich ein Gleichgewicht einstellt. Der Begriff n-Wanne kann hier auch als n-dotiertes Gebiet innerhalb des Substrats Sub verstanden werden. Die anderen n-Wannen bilden mit dem Substrat Sub des CMOS-Schaltkreises und der n-Wanne des High-Side-Ausgangstransistors eine parasitäre NPN-Struktur, die dann hier als parasitärer NPN-Transistor $NPN_{paraH}$ mit einer sehr geringen Verstärkung von typischerweise kleiner 1 angesehen werden kann. Der parasitäre NPN-Transistor $NPN_{paraH}$ kann bei einem ausreichend hohen Entnahmestrom trotz geringer Stromverstärkung öffnen und damit andere n-Wannen mit dem Außenanschlusskontakt PDH auf einem sehr niedrigen Potenzial kurzschließen, was dann zu Fehlern, wie z.B. dem Nichtauslösen von Airbags führen kann, die von anderen Treiberschaltungen der integrierten CMOS-Schaltung gezündet werden sollten. Denn diese weist mehrere Treiberschaltungen auf, wobei je nach Art eines Crashs (z.B. Frontal- oder Seitenaufprall) nicht alle oder andere der zahlreichen im Fahrzeug verbauten Airbags gezündet werden.

In Fig. 1c ist die analoge Situation für einen Low-Side-Ausgangstransistor T1L dargestellt. Die Aufgabe des Low-Side-Ausgangstransistors T1L ist es, den ihm zugeordneten Außenanschlusskontakt PDL, bei dem es sich ebenfalls um einen Außenanschluss des IC handelt, mit dem negativen Versorgungspotenzial der Bezugspotenzialleitung GND (nachfolgend auch Bezugspotenzial GND genannt) zu verbinden. In Airbag-Schaltkreisen handelt es sich dabei typischerweise um den negativen Pol der Energiereserve. Der Low-Side-Ausgangstransistor T1L kann von einer ESD-Schutzschaltung typischerweise über die Steuerelektrode VG1L des Low-Side-Ausgangstransistors T1L eingeschaltet werden. Des Weiteren kann der Low-Side-Ausgangstransistor T1L von einer Funktionsschaltung GC eingeschaltet und ausgeschaltet werden, wobei die ESD-Schutzschaltung typischerweise die Funktionsschaltung GC "überschreiben" kann. Das Problem tritt auf, wenn am Außenanschlusskontakt PDL des Low-Side-Ausgangstransistors T1L ein größerer Strom entnommen wird.

Der Low-Side-Transistor T1H umfasst wieder bevorzugt eine n-dotierte Wanne. Die n-Wanne des Low-Side-Ausgangstransistors T1L ist mit dem Außenanschlusskontakt PDL verbunden. Wird also aus dem Außenanschlusskontakt PDL durch ein bezüglich des Bezugspotenzials der Bezugspotenzialleitung GND negatives Potenzial ein Strom entnommen, so führt dies zu einem Stromfluss aus der n-Wanne des Low-Side-Ausgangstransistors T1L und damit zum Öffnen der unvermeidbaren, parasitären PN-Diode zwischen n-Wanne des Low-Side-Ausgangstransistors T1L und dem Substrat Sub, wenn der Potenzialunterschied zwischen dem Potenzial des Substrats Sub minus dem Potenzial der n-Wanne negativ wird und die negative Schleusenspannung dieser PN-Diode unterschritten wird. Da die CMOS-Schaltung, wie zuvor schon beschrieben, eine Vielzahl von n-Wannen in dem Substrat als Vorrichtungsteile anderer Schaltungsteile OC der CMOS-Schaltung auf Potenzialen oberhalb des Substratpotenzials umfasst, wird nun über die Substratkontakte der CMOS-Schaltung der entnommene Strom nachgeliefert, so dass sich ein Gleichgewicht einstellt. Die anderen n-Wannen bilden mit dem Substrat des CMOS-Schaltkreises und der n-Wanne des High-Side-Ausgangstransistors eine parasitäre NPN-Struktur, die dann hier wiederum als parasitärer NPN-Transistor $NPN_{paraL}$ mit einer sehr geringen Verstärkung von typischerweise kleiner 1 angesehen werden kann. Dieser parasitäre NPN-Transistor $NPN_{paraL}$ kann bei einem ausreichend hohen Entnahmestrom trotz geringer Stromverstärkung öffnen und damit andere n-Wannen mit dem Außenanschlusskontakt PDL auf einem sehr niedrigen Potenzial kurzschließen, was dann zu Fehlern, wie z.B. dem Nichtauslösen von Airbags führen kann, die von anderen Treiberschaltungen der integrierten CMOS-Schaltung gezündet werden sollten.

Fig. 2 zeigt eine typische Airbag-Zündstufe, wie sie im Stand der Technik üblich ist. Der integrierte CMOS-Zündschaltkreis IC wird über eine positive Versorgungsspannungsleitung VDD und eine Bezugspotenzialleitung GND mit elektrischer Energie versorgt. Die Darstellung ist schematisch vereinfacht, um das Verständnis zu erleichtern. Innerhalb der integrierten CMOS-Schaltung IC befindet sich der eigentliche integrierte Schaltkreis IS, der hier in diesem Beispiel die Ansteuerschaltung umfasst, die die Airbag-Zündfunktion steuert und überwacht. Seine Details sind für das Verständnis der Erfindung irrelevant. In den Fign. 1b und 1c ist mit der Funktionsschaltung GC beispielsweise der integrierte Schaltkreis IS der Fig. 2 symbolisiert. Der Schaltkreis IS erzeugt hier das Steuersignal für die Steuerelektrode des High-Side-Ausgangstransistors T1H und überträgt es mittels der Steuersignalleitung VG1H an die Steuerelektrode des High-Side-Ausgangstransistors T1H. Dier Schaltkreis IS erzeugt auch das Steuersignal für die Steuerelektrode des Low-Side-Ausgangstransistors T1L und überträgt es mittels der Steuersignalleitung VG1L an die Steuerelektrode des Low-Side-Ausgangstransistors T1L. Der Schaltkreis IS kann (muss es aber nicht) auch das Steuersignal für die Steuerelektrode des Sicherheitstransistors ST erzeugen und überträgt es mittels der Steuersignalleitung VST über den Außenanschlusskontakt PDG für den Anschluss der Steuerelektrode des Sicherheitstransistors ST an die Steuerelektrode des Sicherheitstransistors ST.

Der Drain-Kontakt des High-Side-Ausgangstransistors T1H ist über den Außenanschlusskontakt PDS mit dem Source-Kontakt des Sicherheitstransistors ST verbunden.

Der Source-Kontakt des High-Side-Ausgangstransistors T1H ist über den Außenanschlusskontakt PDH für den High-Side-Ausgangstransistor T1H mit einem ersten Anschluss eines oder mehrerer Squibs SQ eines Fahrzeuginsassenrückhaltesystems oder einer Fahrzeugsicherheitseinrichtung verbunden. Bei einem Squib SQ handelt es sich typischerweise um eine elektrisch zündbare Sprengladung zur Entfaltung eines Airbags.

Der Drain-Kontakt des Low-Side-Ausgangstransistors T1L ist über den Außenanschlusskontakt PDL für den Low-Side-Ausgangstransistor T1L mit einem zweiten Anschluss des Squib SQ des Fahrzeuginsassenrückhaltesystems oder der Fahrzeugsicherheitseinrichtung verbunden.

Der Source-Kontakt des Low-Side-Ausgangstransistors T1L ist typischer Weise mit der Bezugspotenzialleitung GND verbunden.

Die Stromtragfähigkeit des Low-Side-Ausgangstransistors T1L und des High-Side-Ausgangstransistors T1H sind typischerweise so ausgelegt, dass sie für die sehr kurze Zeit der Zündung des Squibs SQ einen sehr hohen Strom in einem Bereich von mehreren Ampere für eine begrenzte Zahl an Zündzyklen zuverlässig tragen können.

Der Drain-Kontakt des Sicherheitstransistors ST ist typischerweise mit der Versorgungsspannungsleitung VDD verbunden, während sein Source-Kontakt mit dem Außenanschlusskontakt PDS angeschlossen ist.

Die Außenanschlusskontakte PDH und PDS, nachfolgend abgekürzt mit Kontakt oder Kontakte bezeichnet, sind also Außenanschlüsse am IC, an denen im Fahrzeug verlegte Leitungen angeschlossen sind, die zu einem oder mehreren der Treiberstufe aus den High-Side-Transistoren T1H und Low-Side-Transistoren T1L des Squib führen. Wenn diese externen Leitungen durch z.B. eine Beschädigung oder als Folge parasitärer Elemente wie Induktivitäten und Kapazitäten ein nicht vorgesehenes Potenzial führen, kann es, wie zuvor anhand der Fign. 1a, 1b und 1c beschrieben, zu Ausfällen kommen.

Der Erfindung liegt die Aufgabe zugrunde, eine Lösung zu schaffen, die die obigen Nachteile des Stands der Technik, insbesondere hinsichtlich der Ströme in parasitären Strukturen, nicht aufweist und weitere Vorteile bietet.

Die Erfindung betrifft eine Vorrichtung zur Verhinderung der Injektion eines Substratstromes in das Substrat Sub eines CMOS Schaltkreises. Hierzu realisieren die Vorrichtungen in unterschiedlicher Weise Verfahren zur Verhinderung einer solchen Injektion. Sie erfassen das Potenzial eines Kontakts PDH, PDL der integrierten CMOS-Schaltung, vergleichen den Wert des so erfassten Potenzials mit einem Referenzwert und verbinden den Kontakt PDH, PDL mit einem Ableitschaltungsknoten zum Ableiten des Stroms, so dass dieser nicht durch die parasitäre bipolare Lateralstruktur, d.h. nicht im Substrat abfließt. Der Ableitschaltungsknoten kann z.B. mit der Bezugspotenzialleitung GND oder mit einer anderen Leitung verbunden sein, die ein höheres Potenzial als das der Bezugspotenzialleitung GND aufweist. Diese elektrische Verbindung wird dann aktiviert bzw. initiiert, wenn der Wert des Potenzials des Kontakts PDH, PDL unter einem Referenzwert liegt oder gleich diesem ist, wobei dieser Referenzwert unter dem Wert des Potenzials des Substrats Sub liegt und/oder unter dem Wert des Potenzials der Bezugspotenzialleitung GND oder der obengenannten anderen Leitung liegt.

Diese Aufgabe wird durch eine Vorrichtung nach Anspruch 1 gelöst. Einzelne Ausgestaltungen der erfindungsgemäßen Vorrichtung sind Gegenstand der Unteransprüche.

Die Erfindung schlägt eine Vorrichtung zur Verwendung in einem integrierten CMOS-Schaltkreis vor, der in ein mit Ladungsträgern eines ersten Leitungstyps dotiertes Halbleitersubstrat Sub, insbesondere in ein p-dotiertes Halbleitersubstrat Sub, integriert ist, das aufweist

- mehrere mit Ladungsträgern eines zum ersten Leitungstyp entgegengesetzten zweiten Leitungstyps dotierte Gebiete (NG), insbesondere mehrere n-dotierte N-Gebiete (NG), die jeweils elektronische Bauteile bilden oder in denen jeweils elektronische Bauteile ausgebildet sind,

- einen Überwachungsschaltungsknoten (PDH, PDL), der in einem der dotierten Gebiete (NG) liegt oder mit einem oder mehreren der dotierten Gebiete (NG) elektrisch verbunden ist und hinsichtlich seines Potenzials zu überwachen ist,

- wobei das Halbleitersubstrat (Sub) mit einem Substratpotenzial (PSUB) beaufschlagt ist,

- wobei der CMOS-Schaltkreis ein Bezugspotenzial (GND) aufweist, und

- wobei zwischen dem dotierten Gebiet (NG) mit dem Überwachungsschaltungsknoten (PDH, PDL) und mindestens einem zu diesem dotierten Gebiet (NG) benachbarten dotierten Gebiet (NG) oder zwischen mindestens einem der dotierten Gebiete (NG), mit dem oder mit denen der Überwachungsschaltungsknoten (PDH, PDL) elektrisch verbunden ist, und einem zu diesem besagten dotierten Gebiet (NG) benachbarten dotierten Gebiet (NG) oder einem zu einem dieser dotierten Gebiete (NG) benachbarten dotierten Gebiet (NG) eine parasitäre bipolare Lateralstruktur, insbesondere eine parasitäre bipolare NPN-Lateralstruktur, ausgebildet ist,

- einen elektronischen Schalter (T2, T1L) mit einem Leitungspfad, der einerseits elektrisch mit dem Überwachungsschaltungsknoten (PDH, PDL) verbunden ist und andererseits mit einem Ableitschaltungsknoten (ABK) zum Ableiten von Strom aus dem Überwachungsschaltungsknoten (PDH, PDL) elektrisch verbunden ist, und mit einer Steuerelektrode zum Sperrend- und Leitendschalten des Leitungspfades,

- eine Überwachungsschaltung (UVH, UVL) für den Überwachungsschaltungsknoten (PDH, PDL), die einen das Potenzial an dem Überwachungsschaltungsknoten (PDH, PDL) repräsentierenden Potenzialwert erfasst,

- wobei die Überwachungsschaltung (UVH, UVL) eine Vergleicherschaltung aufweist, die den erfassten Potenzialwert mit einem vorgegebenen Referenzpotenzial vergleicht,

- wobei das Referenzpotenzial gleich dem oder kleiner als das Substratpotenzial (PSUB) oder gleich sowohl dem Substratpotenzial (PSUB) als auch dem Bezugspotenzial (GND) oder kleiner als sowohl das Substratpotenzial (PSUB) als auch das Bezugspotenzial (GND) ist und

- wobei die Überwachungsschaltung (UVH, UVL) ein Einschaltsignal zum Leitendschalten des elektronischen Schalters (T2, T1L) direkt oder indirekt erzeugt, wenn der erfasste Potenzialwert gleich dem Referenzpotenzial ist oder unterhalb des Referenzpotenzials liegt,

- einen ersten Transistor (T4) mit einem Source-Anschluss, einem Drain-Anschluss und einer Steuerelektrode,

- einen zweiten Transistor (T5) mit einem Source-Anschluss, einem Drain-Anschluss und einer Steuerelektrode,

- eine erste Stromquelle (IQ1) für die Ausgabe eines ersten Stroms (I1) mit einem Ausgangsanschluss,

- wobei der Ausgangsanschluss der ersten Stromquelle (IQ1) mit dem Drain-Anschluss des ersten Transistors (T4) elektrisch verbunden ist, dessen Source-Anschluss mit dem Bezugspotenzial (GND) elektrisch verbunden ist,

- eine zweite Stromquelle (IQ2) für die Ausgabe eines zweiten Stroms (I2) mit einem Ausgangsanschluss, der mit dem Drain-Anschluss des zweiten Transistors (T5) elektrisch verbunden ist, dessen Source-Anschluss mit dem Überwachungsschaltungsknoten (PDH, PDL) elektrisch verbunden oder unter Zwischenschaltung eines Widerstands (R4) mit dem Überwachungsschaltungsknoten (PDH, PDL) elektrisch verbunden oder unter Zwischenschaltung einer Diode (D2), deren Anode mit dem Source-Anschluss des zweiten Transistors (T5) und deren Kathode mit dem Überwachungsschaltungsknoten (PDH, PDL) elektrisch verbunden ist, mit dem Überwachungsschaltungsknoten (PDH, PDL) elektrisch verbunden oder unter Zwischenschaltung einer Reihenschaltung aus einer Diode (D2) und einem Widerstand (R4) mit dem Überwachungsschaltungsknoten (PDH, PDL) elektrisch verbunden ist, wobei entweder die Kathode der Diode (D2) mit dem Source-Anschluss des zweiten Transistors (T5) oder die Anode der Diode (D2) mit dem Überwachungsschaltungsknoten (PDH, PDL) elektrisch verbunden ist,

- wobei der Ausgangsanschluss der ersten Stromquelle (IQ1) mit der Steuerelektrode des ersten Transistors (T4) elektrisch verbunden ist,

- wobei der Drain-Anschluss des ersten Transistors (T4) mit der Steuerelektrode des zweiten Transistors (T5) elektrisch verbunden ist, und

- einen Verstärker (V) mit negativer Verstärkung mit einem Eingang, der mit dem Ausgangsanschluss der zweiten Stromquelle (IQ2) elektrisch verbunden ist, und mit einem Ausgang (OPOL, OPOH) zur Ausgabe des Einschaltsignals für den elektronischen Schalter (T2, T1L),

- wobei der Ausgang (OPOL, OPOH) des Verstärkers (V) mit der Steuerelektrode des elektronischen Schalters (T2, T1L) elektrisch verbunden oder mit dieser unter Zwischenschaltung einer Diode (D1) elektrisch verbunden ist, die eine mit der Steuerelektrode des elektronischen Schalters (T2, T1L) elektrisch verbundene Kathode und eine mit dem Ausgang (OPOL, OPOH) des Verstärkers (V) elektrisch verbundene Anode aufweist.

Sinngemäß wird mit der Erfindung gemäß dieser und der weiteren Varianten vorgeschlagen, das Potenzial eines Schaltungsknotens zu überwachen, der bei Unterschreitung eines Referenzpotenzials unbeabsichtigt eine parasitäre bipolare Lateralstruktur, die im Halbleitersubstrat ausgebildet ist, aktivieren könnte. Das würde bedeuten, dass im Halbleitersubstrat Substratströme entstehen, die die Funktion benachbarter aktiver Gebiete des Halbleitersubstrats, in denen weitere elektronische Bauteile und Schaltkreise ausgebildet sind, stören können. Dies wird erfindungsgemäß verhindert, indem das Potenzial am besagten zu überwachenden Schaltungsknoten (nachfolgend Überwachungsschaltungsknoten genannt) mit dem Referenzpotenzial verglichen wird, um bei Unterschreitung des Referenzpotenzials oder bei Gleichheit mit diesem Referenzpotenzial für einen Stromfluss zu sorgen, der sich nicht im Halbleitersubstrat "ausbreitet" sondern innerhalb eines oder mehrerer aktiver Gebiete des Halbleitersubstrats fließt. Hierzu wird erfindungsgemäß ein elektronischer Schalter verwendet, der zwischen den Überwachungsschaltungsknoten und einen Ableitschaltungsknoten geschaltet ist. Wenn das Potenzial des Überwachungsschaltungsknotens gleich dem Referenzpotenzial ist oder bis unterhalb dieses Referenzpotenzials absinkt, wird der elektronische Schalter eingeschaltet (beispielsweise ein Schalttransistor leitend geschaltet), um das Potenzial am Überwachungsschaltungsknoten wieder anzuheben. Der Ableitschaltungsknoten führt also ein Potenzial, das oberhalb des Referenzpotenzials liegt. Dieses Referenzpotenzial wiederum kann gleich dem oder kleiner als das Bezugspotenzial sein, bei dem es sich im Regelfall um Masse handelt, oder gleich dem oder kleiner als das Substratpotenzial sein, auf dem das Halbleitersubstrat liegt. Die erfindungsgemäße Idee ist es nun, durch den elektronischen Schalter im Bedarfsfalle den hinsichtlich seines Potenzials zu überwachenden Knoten potenzialmäßig wieder anzuheben, wenn sein Potenzial, von einem höheren Wert kommend, bis auf das Referenzpotenzial oder bis unterhalb des Referenzpotenzials abfällt. Vorteilhafterweise sollte die Potenzialdifferenz zwischen Überwachungsschaltungsknoten und Ableitschaltungsknoten ausreichend hoch für die erfindungsgemäße Funktion der Spannungslimitierung am Überwachungsschaltungsknoten sein, andererseits aber auch vorteilhafterweise nicht zugleich auch zu hoch gewählt werden, um die zur Aufrechterhaltung dieses Potenzial am Ableitschaltungsknoten aufzuwendende elektrische Leistung zu minimieren. Der Ableitschaltungsknoten sollte möglichst niederohmig sein. Grundsätzlich erfüllt das Massepotenzial all diese Eigenschaften, da es sowohl eine geringe Impedanz als auch oberhalb des Referenzpotenzials liegt, mit anderen Worten also das Referenzpotenzial so gewählt wird, dass es unterhalb des Massepotenzials liegt.

Die zuvor genannten Überlegungen hinsichtlich der Beschaffenheit des Ableitschaltungsknotens und des Potenzials, mit diesem dieser beaufschlagt ist, gilt ganz grundsätzlich für sämtliche Ausgestaltungen der Erfindung.

In zweckmäßiger Weiterbildung der Erfindung kann vorgesehen sein, dass der Überwachungsschaltungsknoten PDH, PDL ein nach außen geführter oder nach außen zu führender Außenanschlusskontakt des CMOS-Schaltkreises ist oder mit einem nach außen geführten oder nach außen zu führenden Außenanschlusskontakt des CMOS-Schaltkreises elektrisch verbunden ist. Wie bereits oben im Zusammenhang mit der im Stand der Technik mitunter anzutreffenden Problematik beschrieben, sind insbesondere solche Knoten einer integrierten CMOS-Schaltung hinsichtlich ihres Potenzials zu überwachen, die entweder einen Außenanschlusskontakt des IC-Bauteils bilden oder mit einem derartigen Außenanschlusskontakt verbunden sind. Durch äußere Einflüsse können derartige Außenanschlusskontakte, die typischerweise in Form von Anschlussbeinchen oder Anschlussflächen von gehäusten ICs ausgeführt sind, unbeabsichtigt mit elektrischen Potenzialen beaufschlagt werden, die für die Funktionstüchtigkeit des CMOS-Schaltkreises nachteilig sein können, was oben im Einzelnen beschrieben ist.

In weiterer vorteilhafter Ausgestaltung der Erfindung kann vorgesehen sein, dass der Überwachungsschaltungsknoten PDH, PDL der Ausgang eines Transistors einer Ausgangstreiberstufe des CMOS-Schaltkreises ist.

Schließlich kann bei der zuvor genannten Ausgestaltung der Erfindung der Transistor der Ausgangstreiberstufe ein an das Bezugspotenzial GND angeschlossener Low-Side-Transistor T1L sein, wobei der elektronische Schalter T2 zwischen den Überwachungsschaltungsknoten PDH, PDL und den Ableitschaltungsknoten ABK angeordnet ist (mit anderen Worten hinsichtlich seines Leitungspfads also parallel zu Low-Side-Transistor T1L geschaltet ist).

In weiterer vorteilhafter Ausgestaltung der zuvor beschriebenen Variante kann der Transistor der Ausgangstreiberstufe ein an das Bezugspotenzial GND angeschlossener Low-Side-Transistor T1L sein, wobei dieser Low-Side-Transistor T1L den elektronischen Schalter bildet. Dies ist von besonderer Bedeutung und beispielsweise möglich mit Transistoren, die entweder am Bezugspotenzial angeschlossen sind, wie dies beispielsweise an einem Low-Side-Transistor einer Ausgangstreiberstufe der Fall, oder mit dem Ableitschaltungsknoten verbunden sind. Ein derartiger Transistor, der auch für den normalen Betrieb der CMOS-Schaltung eingesetzt wird, kann dann im Bedarfsfalle leitend geschaltet werden und übernimmt dann die Funktion des Anhebens des Potenzials am Überwachungsschaltungsknoten auf das Bezugspotenzial bzw. auf das Potenzial des Ableitschaltungsknotens. Der funktionsmäßig vorgeschriebene Betrieb eines derartigen Transistors, der Teil eines bestimmungsgemäß arbeitenden CMOS-Schaltkreises ist, bleibt dabei erhalten. Man kann sich also sozusagen den erfindungsgemäß vorgesehenen elektronischen Schalter bei diesen Anwendungen "sparen".

Bei einer weiteren Variante der erfindungsgemäßen Vorrichtung ist der Transistor der Ausgangstreiberstufe ein direkt oder indirekt mit einem Versorgungspotenzial VDD verbundener High-Side-Transistor T1H der Ausgangstreiberstufe, wobei der elektronische Schalter T2 zwischen dem Überwachungsschaltungsknoten PDH, PDL des High-Side-Transistors T1H und dem Ableitschaltungsknoten ABK angeordnet ist.

Für die Anzeige bzw. Signalisierung des Umstandes, dass die erfindungsgemäß vorgesehene Überwachungsschaltung für den Überwachungsschaltungsknoten ein Signal zum Leitendschalten des elektronischen Schalters ausgibt, kann die Überwachungsschaltung ein diesbezügliches Statussignal erzeugen, und zwar entweder intern oder für die externe Weiterverarbeitung. Die Information über die Erzeugung dieses Statussignals kann temporär oder dauerhaft in einem Speicher abgespeichert werden oder aber es wird ein Speicher zur temporären oder dauerhaften Speicherung einer Information über die Erzeugung des Statussignals vorgesehen.

In weiterer vorteilhafter Ausgestaltung der Erfindung kann vorgesehen sein, dass der CMOS-Schaltkreis ein mit dem Überwachungsschaltungsknoten PDH, PDL elektrisch verbundenes, ansteuerbares, elektronisches Bauteil, wie z.B. einen Transistor, einen Thyristor o.dgl., und eine Ansteuerschaltung IS, GC zur Ansteuerung des Bauteils zwecks bestimmungsgemäßer Funktion dieses Bauteils und weiterer mit diesem Bauteil elektrisch zusammenwirkender Bauteile aufweist. Wie bereits oben beschrieben, ist an den Überwachungsschaltungsknoten typischerweise ein für die Funktion des CMOS-Schaltkreises gedachtes elektronisches Bauteil angeschlossen, wie beispielsweise ein Transistor oder ein Thyristor oder anderweitiges ansteuerbares elektronisches Bauteil. Die Ansteuerung dieser Typen von für die Funktion des CMOS-Schaltkreises gedachter elektronischer Bauteile erfolgt durch eine Ansteuerschaltung für den bestimmungsgemäßen Betrieb des CMOS-Schaltkreises.

Bei einer zweckmäßigen Ausgestaltung der Erfindung ist vorgesehen,

- dass die Vergleicherschaltung einen Operationsverstärker OP mit einem positiven Eingangsanschluss IP sowie einem negativen Eingangsanschluss IN und mit einem Ausgangsanschluss OPOH, OPOL aufweist,
- dass das Referenzpotenzial von einer Referenzspannungsquelle Vref bereitgestellt ist (die beispielsweise zwischen das Bezugspotenzial GND und den positiven Eingangsanschluss IP des Operationsverstärkers OP geschaltet ist),

- dass der negative Eingangsanschluss IN des Operationsverstärkers OP mit dem Überwachungsschaltungsknoten PDH, PDL verbunden oder mit diesem unter Zwischenschaltung einer Diode D2 verbunden ist, die eine mit dem Überwachungsschaltungsknoten PDH, PDL elektrisch verbundene Kathode und eine mit dem negativen Eingangsanschluss IN des Operationsverstärkers OP elektrisch verbundene Anode aufweist, und
- dass der Ausgangsanschluss OPOH, OPOL des Operationsverstärkers OP mit der Steuerelektrode des elektronischen Schalters T2, T1L elektrisch verbunden oder mit dieser unter Zwischenschaltung einer Diode D1 verbunden ist, die eine mit der Steuerelektrode des elektronischen Schalters T2, T1L elektrisch verbundene Kathode und eine mit dem Ausgangsanschluss OPOH, OPOL des Operationsverstärkers OP elektrisch verbundene Anode aufweist.

An die Verbindung des Ausgangsanschlusses OPOH, OPOL des Operationsverstärkers OP mit der Steuerelektrode des elektronischen Schalters T2, T1L kann ein Pull-Down-Widerstand R6 elektrisch angeschlossen sein, der mit dem Bezugspotenzial GND elektrisch verbunden ist.

Fall gewünscht, kann der Operationsverstärker OP an seinem Ausgangsanschluss OPOH, OPOL das Einschaltsignal zum Leitendschalten des elektronischen Schalters T2, T1L erzeugen und an dessen Steuerelektrode ausgeben, wenn der erfasste Potenzialwert gleich dem Referenzpotenzial oder unterhalb des Referenzpotenzials liegt, wobei der Operationsverstärker OP das Statussignal ausgibt und das Einschaltsignal auch als Statussignal genutzt werden kann.

Die Erfindung zeichnet sich also u.a. aus durch

- einen ersten Transistor T4 mit einem Source-Anschluss, einem Drain-Anschluss und einer Steuerelektrode,
- einen zweiten Transistor T5 mit einem Source-Anschluss, einem Drain-Anschluss und einer Steuerelektrode,
- eine erste Stromquelle IQ1 für die Ausgabe eines ersten Stroms I1 mit einem Ausgangsanschluss,
- einen Widerstand R3,
- wobei der Ausgangsanschluss der ersten Stromquelle IQ1 mit dem Widerstand R3 elektrisch verbunden und dieser mit dem Drain-Anschluss des ersten Transistors T4 elektrisch verbunden ist, dessen Source-Anschluss mit dem Bezugspotenzial GND elektrisch verbunden ist,
- eine zweite Stromquelle IQ2 für die Ausgabe eines zweiten Stroms I2 mit einem Ausgangsanschluss, der mit dem Drain-Anschluss des zweiten Transistors T5 elektrisch verbunden ist, dessen Source-Anschluss mit dem Überwachungsschaltungsknoten PDH, PDL elektrisch verbunden ist oder mit diesem unter Zwischenschaltung einer Reihenschaltung aus einem Widerstand R4 und einer eine Anode und eine Kathode aufweisenden Diode D2 elektrisch verbunden ist, wobei entweder die Anode der Diode D2 mit dem Source-Anschluss des zweiten Transistors T5 sowie die Kathode der Diode D2 mit dem Widerstand R4 und der Widerstand R4 mit dem Überwachungsschaltungsknoten PDH, PDL elektrisch verbunden oder der Widerstand R4 mit dem Source-Anschluss des zweiten Transistors T5 und die Anode der Diode D2 mit dem Widerstand R4 sowie die Kathode der Diode D2 mit dem Überwachungsschaltungsknoten PDH, PDL elektrisch verbunden sind, wobei der Ausgangsanschluss der ersten Stromquelle IQ1 mit der Steuerelektrode des ersten Transistors T4 elektrisch verbunden ist,

- wobei der Drain-Anschluss des ersten Transistors T4 mit der Steuerelektrode des zweiten Transistors T5 elektrisch verbunden ist, und

- einen Verstärker V mit negativer Verstärkung mit einem Eingang, der mit dem Ausgangsanschluss der zweiten Stromquelle IQ2 (und damit mit dem Drain-Anschluss des zweiten Transistors) elektrisch verbunden ist, und mit einem Ausgang OPOL, OPOH zur Ausgabe des Einschaltsignals für den elektronischen Schalter T2, T1L,

- wobei der Ausgang OPOL, OPOH des Verstärkers V mit der Steuerelektrode des elektronischen Schalters T2, T1L elektrisch verbunden oder mit dieser unter Zwischenschaltung einer Diode D1 elektrisch verbunden ist, die eine mit der Steuerelektrode des elektronischen Schalters T2, T1L elektrisch verbundene Kathode und eine mit dem Ausgang OPOL, OPOH des Verstärkers V elektrisch verbundene Anode aufweist.

In vorteilhafter Ausgestaltung der Erfindung kann vorgesehen sein, dass der Überwachungsschaltungsknoten PDH, PDL ein nach außen geführter oder nach außen zu führender Außenanschlusskontakt des CMOS-Schaltkreises ist oder mit einem nach außen geführten oder nach außen zu führenden Außenanschlusskontakt des CMOS-Schaltkreises elektrisch verbunden ist.

In weiterer vorteilhafter Ausgestaltung der Erfindung kann vorgesehen sein, dass der Überwachungsschaltungsknoten PDH, PDL der Ausgang eines Transistors einer Ausgangstreiberstufe des CMOS-Schaltkreises ist.

Ferner kann erfindungsgemäß vorgesehen sein, dass der Transistor der Ausgangstreiberstufe ein an das Bezugspotenzial GND angeschlossener Low-Side-Transistor T1L ist und dass der elektronische Schalter zwischen den Überwachungsschaltungsknoten PDH, PDL und den Ableitschaltungsknoten ABK angeordnet ist (mit anderen Worten hinsichtlich seines Leitungspfads also parallel zu Low-Side-Transistor T1L geschaltet ist).

In vorteilhafter Ausgestaltung der Erfindung kann vorgesehen sein, dass der Transistor der Ausgangstreiberstufe ein an das Bezugspotenzial GND angeschlossener Low-Side-Transistor T1L ist und dass der Low-Side-Transistor T1L den elektronischen Schalter bildet.

In weiterer vorteilhafter Ausgestaltung der Erfindung kann vorgesehen sein, dass der Transistor der Ausgangstreiberstufe ein direkt oder indirekt mit einem Versorgungspotenzial VDD verbundener High-Side-Transistor T1H der Ausgangstreiberstufe ist und dass der elektronische Schalter T2 zwischen dem Überwachungsschaltungsknoten PDH, PDL des High-Side-Transistors T1H und dem Ableitschaltungsknoten ABK angeordnet ist.

Bei einer zweckmäßigen Ausgestaltung der Erfindung ist vorgesehen, dass die Überwachungsschaltung UVH, UV ein Statussignal zur Signalisierung eines Leitendschaltens des elektronischen Schalters T2, T1L ausgibt.

Die obige Aufgabe wird also durch eine Vorrichtung zur Verwendung in einem integrierten CMOS-Schaltkreis gelöst. Eine mögliche Vorrichtung umfasst einen Kontakt PDH, PDL des CMOS-Schaltkreises, der ein p-dotiertes Substrat Sub mit einem n-dotierten N-Gebiet NG aufweist. Das N-Gebiet NG liegt innerhalb des p-dotierten Substrats Sub. Des Weiteren umfasst die Vorrichtung eine Leitung PDCH, PDCL, eine Bezugspotenzialleitung GND, einen Ausgangstransistor T1H, T1L, eine Funktionsschaltung GC und optional eine ESD-Schutzschaltung. Das N-Gebiet ist mit der Ausgangsleitung PDCH, PDCL elektrisch verbunden, welche wiederum zum Kontakt PDH, PDL führt. Eine optionale ESD-Schutzschaltung kann den Ausgangstransistor T1H, T1L im Falle eines ESD-Ereignisses gegebenenfalls einschalten. Die Funktionsschaltung GC, die die eigentliche Funktion des CMOS-Schaltkreises darstellt, kann den Ausgangstransistor T1H, T1L jeweils ein- und ausschalten. Der ESD-Schaltkreis kann dabei bevorzugt den Steuerungsbefehl der Funktionsschaltung GC für den Ausgangstransistor T1H, T1L "überschreiben".

Die erfindungsgemäße Vorrichtung umfasst bevorzugt nun einen Schalttransistor T2, der im Falle der Überwachung des Potenzials an einem mit einem Low-Side-Ausgangstransistor T1L verbundenen Außenkontakt PDL, PDH bevorzugt identisch mit diesem Ausgangstransistor T1L ist und im Falle eines High-Side-Ausgangstransistors T1H bevorzugt separat von diesem High-Side-Ausgangstransistor T1H ausgeführt ist. Ein Vorteil ist dabei, dass im Falle eine High-Side-Ausgangstransistors T1H der zusätzliche Schalttransistor T2 dabei auch den ESD-Schutz für den zugehörigen Kontakt PDH gegen die Bezugspotenzialleitung GND übernehmen kann, wie weiter unten im Zusammen mit der Figurenbeschreibung noch näher erläutert wird. Die Vorrichtung umfasst bevorzugt eine Überwachungsschaltung UVH, UVL. Die Überwachungsschaltung UVH, UVL erfasst das Potenzial des Kontakts PDL, PDH und vergleicht den Wert des Potenzials des Kontakts PDL, PDH mit einem Referenzwert, bevorzugt mit einer Referenzspannung. Diese kann gegebenenfalls innerhalb der Überwachungsschaltung UVH, UVL aus den Betriebsspannungen erzeugt werden. Die Überwachungsschaltung UVH, UVL schaltet nun den Schalttransistor T2, T1L ein, wenn der Wert des Potenzials des Kontakts PDH, PDL unter dem Referenzwert liegt. Hierbei ist für die Lösung des Problems wichtig, dass dieser Referenzwert bevorzugt unter dem Wert des Potenzials des Substrats Sub liegt und/oder unter dem Wert des Potenzials der Bezugspotenzialleitung GND liegt. Hierdurch übernimmt der Schalttransistor T2, T1L einen Großteil des fehlerhaft am Kontakt PDH, PDL entnommenen Stromes, der daher nicht mehr durch die Basis-Emitter-Diode des parasitären NPN-Bipolar-Transistors $NPN_{paraH}$, $NPN_{paraL}$ fließt. Damit ist dieser parasitäre Basis-Emitter-Strom nicht mehr in der Lage, den parasitären NPN-Transistor $NPN_{paraH}$, $NPN_{paraL}$ durchzuschalten und so gegebenenfalls verstärkte Substratströme hervorzurufen und/oder Wannenisolierungen aufzuheben und/oder Knoten- oder Wannenpotenziale innerhalb der CMOS-Schaltung zu verziehen.

Der Schalttransistor T2, T1L verbindet somit den Kontakt PDH, PDL mit einer Bezugspotenzialleitung GND, wenn er infolge eines fehlerhaften Potenzials des Kontakts PDH, PDL durch die Überwachungsschaltung UVH, UVL eingeschaltet wird.

In einer Fortbildung dieser Grundstruktur kann ein gegebenenfalls zusätzlicher Ausgang der Überwachungsschaltung UVH, UVL dazu verwendet werden, eine Signalisierung für eine Stromentnahme am Kontakt PDH, PDL zu erzeugen, wobei diese Signalisierung dann bevorzugt anzeigt, dass der Schalttransistor T2, T1L durch die Überwachungsschaltung UVH, UVL eingeschaltet ist oder eingeschaltet wurde. Somit wird die Vorrichtung in die Lage versetzt, diesen Fehlerzustand zu erkennen und gegebenenfalls vorbeugende Maßnahmen für den Fall zu treffen, dass die Stromentnahme über den Kontakt PDH, PDL solch große Ausmaße annimmt, dass die Stromnachlieferung über den Schalttransistor T2, T1L nicht mehr ausreicht.

Eine mögliche Realisierung einer Überwachungsschaltung für eine Vorrichtung der zuvor beschriebenen Art kann nun so aussehen, dass sie beispielsweise einen Differenzverstärker OP und eine Referenzspannungsquelle Vref umfasst. Dabei erfasst der Operationsverstärker OP an seinem negativen Eingang IN bevorzugt direkt oder über eine Diode D2 und damit indirekt das Potenzial des Kontakts PDL/PDH und an seinem positiven Eingang IP das Potenzial der Referenzspannungsquelle Vref. Hierbei kann dann bevorzugt der Operationsverstärker OP mittels seines Ausgangs OPOH, OPOL direkt oder indirekt über eine weitere Diode D1 den Schalttransistor T2, T1L einschalten.

Die Zusammenschaltung der mehreren Treiber der Steuerelektrode des Schalttransistors T2, T1L wird vorteilhafter Weise so gestaltet, dass bevorzugt der typischerweise vorhandene ESD-Schutz die höchste Priorität hinsichtlich des Einschaltens des Schalttransistors T2, T1L hat, das Einschalten durch den Operationsverstärker OP die nächst höchste Priorität hat und damit die Ansteuerung durch die Funktionsschaltung GC unter diesen drei Einschaltmöglichkeiten die niedrigste Priorität hat.

In einer Fortbildung dieser Konstruktion ist die Referenzspannung der Referenzspannungsquelle Vref so gewählt, dass der Operationsverstärker OP den Schalttransistor T2, T1L mittels seines Ausgangs OPOH, OPOL einschaltet, wenn der Wert des Potenzials des Kontakts PDH, PDL unter dem Wert des Potenzials des Substrats Sub liegt und/oder unter dem Wert des Potenzials der Bezugspotenzialleitung GND liegt.

In einer weiteren Fortbildung dieser Konstruktion wird ein gegebenenfalls zusätzlicher Ausgang des Operationsverstärkers OP dazu verwendet, die besagte Signalisierung für eine Stromentnahme am Kontakt PDH, PDL zu erzeugen. Wie zuvor erwähnt, zeigt dann diese Signalisierung in analoger Weise an, dass der Schalttransistor T2, T1L durch den Operationsverstärker OP eingeschaltet ist oder eingeschaltet wurde.

Im Folgenden wird nun eine konkrete Realisierung dieser Operationsverstärkerschaltung beschrieben. Die konkrete, sehr kompakte Realisierung umfasst einen vierten Transistor T4, einen fünften Transistor T5, einen dritten Widerstand R3, eine erste Stromquelle IQ1, eine zweite Stromquelle IQ2, einen ersten Knoten K1, einen zweiten Knoten K2 und einen dritten Knoten K3. Der dritte Widerstand R3 weist einen ersten Anschluss und einen zweiten Anschluss auf.

Der vierte Transistor T4 ist mit seinem Source-Anschluss mit einem Bezugspotenzial GND verbunden. Der vierte Transistor ist mit seinem Drain-Anschluss mit dem zweiten Knoten K2 verbunden. Die Steuerelektrode des vierten Transistors T4 ist mit dem ersten Knoten K1 verbunden.

Der erste Anschluss des dritten Widerstands R3 ist mit dem ersten Knoten K1 verbunden. Der zweite Anschluss des dritten Widerstands R3 ist mit dem zweiten Knoten K2 verbunden.

Der Source-Anschluss des fünften Transistors T5 ist direkt oder indirekt insbesondere über eine zweite Diode D2 mit dem zu überwachenden Außenkontakt PDL, PDH verbunden. Die Steuerelektrode des fünften Transistors T5 ist mit dem zweiten Knoten K2 verbunden. Der Drain-Anschluss des fünften Transistors T5 ist mit dem dritten Kontakt K3 verbunden.

Ein möglicher Wertebereich des Potenzials des dritten Kontakts K3 kann zu einem Einschalten des Schalttransistors T2 führen, wie weiter unten noch beschrieben wird

Die erste Stromquelle IQ1 speist einen ersten Strom I1 in den ersten Knoten K1 ein. Die zweite Stromquelle IQ2 speist einen zweiten Strom I2 in den dritten Knoten K3 ein.

Diese Konstruktion und Funktionsprinzipien der erfindungsgemäßen Vorrichtung können, um eines von mehreren möglichen Anwendungsbeispielen zu nennen, auf eine Airbag-Zündstufe übertragen werden.

Eine solche Airbag-Zündstufe umfasst ein Substrat Sub für die CMOS-Schaltung, in dem sich der High-Side-Ausgangstransistor T1H und der Low-Side-Ausgangstransistor T1L befinden. Ein Zündelement SQ, das Squib, ist zwischen den Low-Side-Ausgangstransistor T1L und den High-Side-Ausgangstransistor T1H in Serie geschaltet, wie es im Stand der Technik üblich ist. Das Zündelement SQ weist typischerweise einen ersten Anschluss und einen zweiten Anschluss auf. Die Anwendung der Erfindung für die Airbag-Zündstufe zeichnet sich nun dadurch aus, dass die Airbag-Zündstufe mit zumindest einer Überwachungsschaltung UVH, UVL versehen ist. Sie verfügt über Mittel (nämlich hier beispielhaft in Form der Schalttransistoren T1L, T2), um zumindest einen Anschluss des Zündelements mit einer Bezugspotenzialleitung GND zu verbinden, wobei diese Mittel T1L, T2 durch unter anderem die Überwachungsschaltung UVH, UVL gesteuert werden können. Hierbei ist zu beachten, dass in einigen Fällen, wie zuvor beschrieben, diese Mittel, insbesondere der Low-Side-Ausgangstransistor T1L eine Doppelfunktion erfüllen können. Die Überwachungsschaltung UVH, UVL erfasst das Potenzial mindestens eines der Anschlüsse des Zündelements SQ. Gegebenenfalls veranlasst die Überwachungsschaltung UVH, UVL die Mittel T1L, T2 dazu, den besagten einen Anschluss des Zündelements mit der Bezugspotenzialleitung GND zu verbinden, wenn der Wert des erfassten Potenzials des zumindest einen Anschlusses PDH, PDL unter dem Wert des Potenzials des Substrats Sub liegt und/oder unter dem Wert des Potenzials der Bezugspotenzialleitung GND oder unter dem Wert eines Referenzpotenzials Vref, das auf das Potenzial der Bezugspotenzialleitung GND typischerweise bezogen ist, liegt.

Während die vorherige Beschreibung auch eine Airbag-Zündstufe mit einer Überwachungsschaltung an lediglich einem der beiden Anschlüsse des Zündelements SQ betrifft, ist es günstiger, beide Anschlüsse des Zündelements SQ zu überwachen.

Eine solche Airbag-Zündstufe umfasst wiederum ein Substrat Sub mit einem High-Side-Ausgangstransistor T1H und mit einem Low-Side-Ausgangstransistor T1L. Das Zündelement SQ, also das Squib, ist zwischen den Low-Side-Ausgangstransistor T1L und den High-Side-Ausgangstransistor T1H in Serien geschaltet, wie es im Stand der Technik üblich ist. Das Zündelement SQ weist typischerweise einen ersten Anschluss und einen zweiten Anschluss auf. Die Anwendung der Erfindung zeichnet sich nun dadurch aus, dass die Airbag-Zündstufe mit einer ersten Überwachungsschaltung UVH und mit einer zweiten Überwachungsschaltung UVL versehen wird. Die Airbag-Zündstufe umfasst erste Mittel (hier in Form des Schalttransistors T2), um den ersten Anschluss PDH des Zündelements mit einer Bezugspotenzialleitung GND zu verbinden, und zweite Mittel (hier in Form des Low-Side-Ausgangstransistors T1L), um den zweiten Anschluss PDL des Zündelements mit einer Bezugspotenzialleitung GND zu verbinden. Die ersten Mittel T2 können durch die erste Überwachungsschaltung UVH gesteuert werden. Die zweiten Mittel T1L können durch die zweite Überwachungsschaltung UVL gesteuert werden. Die erste Überwachungsschaltung UVH erfasst das erste Potenzial des ersten Anschlusses PDH des Zündelements SQ. Die zweite Überwachungsschaltung UVL erfasst das zweite Potenzial des zweiten Anschlusses PDL des Zündelements SQ. Die erste Überwachungsschaltung UVH veranlasst die ersten Mittel T2 dazu, den ersten Anschluss PDH des Zündelements SQ mit der Bezugspotenzialleitung GND zu verbinden, wenn der Wert des erfassten ersten Potenzials des ersten Anschlusses PDH unter dem Wert des Potenzials des Substrats Sub liegt und/oder unter dem Wert des Potenzials der Bezugspotenzialleitung GND und/oder unter dem Wert einer Referenzspannung Vref, die auf das Potenzial der Bezugspotenzialleitung GND bezogen ist, liegt. Die zweite Überwachungsschaltung UVL veranlasst die zweiten Mittel T1L dazu, den zweiten Anschluss PDL des Zündelements SQ mit der Bezugspotenzialleitung GND zu verbinden, wenn der Wert des erfassten zweiten Potenzials des zweiten Anschlusses PDL unter dem Wert des Potenzials des Substrats Sub liegt und/oder unter dem Wert des Potenzials der Bezugspotenzialleitung GND liegt.

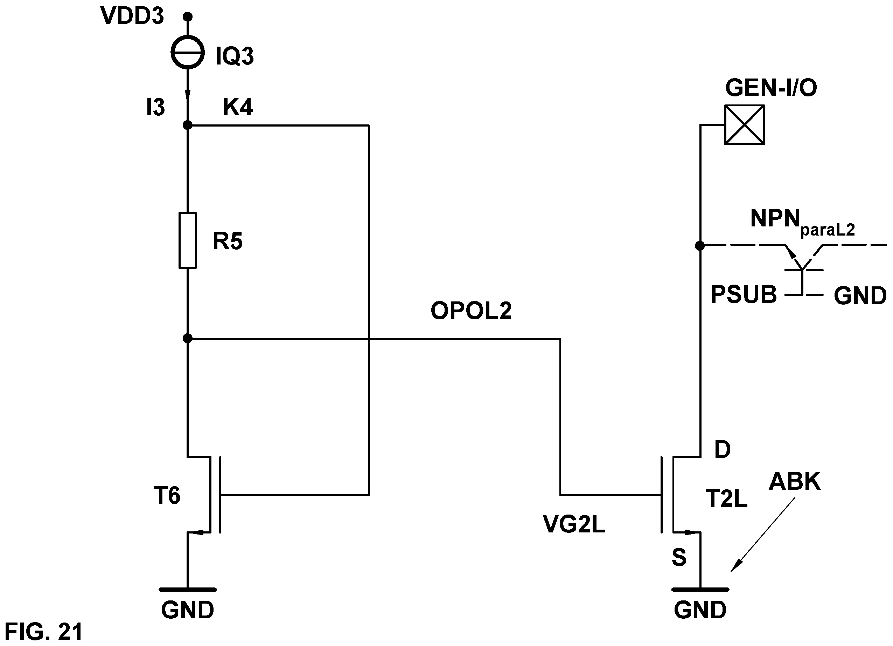

Der Vollständigkeit halber wird im Folgenden als weitere Ausführung des Prinzips einer IC-Ausgangsschaltstufe (Fig. 21) für den Low-Side-Ausgangstransistor T1L vorgestellt, bei dem der Low-Side-Ausgangstransistor T1L selbst als Spannungsmessmittel verwendet wird, um sich selbst einzuschalten. Es ist somit ausdrücklich Teil der Erfindung, dass ein Ausgangstransistor T1L, T1H als Teil der ihm zugeordneten Überwachungsschaltung UVH, UVL genutzt wird bzw. genutzt werden kann.

Eine solche Schaltstufe umfasst einen Kontakt PDL, eine dritte Stromquelle IQ3, einen fünften Widerstand R5, einen sechsten Transistor T6, einen vierten Knoten K4, einen Ausgang OPOL, eine Low-Side-Anschlussleitung PDCL und eine Bezugspotenzialleitung GND. Der sechste Transistor T6 weist einen ersten Anschluss und einen zweiten Anschluss und einen Steueranschluss auf. Der Low-Side-Ausgangstransistor T1L weist einen ersten Anschluss und einen zweiten Anschluss und einen Steueranschluss auf. Die dritte Stromquelle IQ3 speist einen dritten Strom I3 in den vierten Knoten K4 ein. Der erste Anschluss des sechsten Transistors T6 ist elektrisch mit dem Ausgang OPOL der Schaltstufe verbunden. Der zweite Anschluss des sechsten Transistors T6 ist elektrisch mit der Bezugspotenzialleitung GND verbunden. Der Steueranschluss des sechsten Transistors T6 ist elektrisch mit dem vierten Knoten K4 verbunden. Der erste Anschluss des Low-Side-Ausgangstransistors T1L ist elektrisch mit der Low-Side-Anschlussleitung PDCL verbunden. Der zweite Anschluss des Low-Side-Ausgangstransistors T1L ist elektrisch mit der Bezugspotenzialleitung GND verbunden. Der Steueranschluss des Low-Side-Ausgangstransistors T1L ist elektrisch mit dem Ausgang OPOL der Schaltstufe verbunden.

Die Erfindung ermöglicht die zumindest teilweise Vermeidung der Injektion von Strömen in Fehlerfällen in das Substrat von IC-Schaltungen, wo derartige Ströme die Funktionstüchtigkeit anderer integrierter Schaltungskomponenten beeinflussen oder sogar zu Ausfällen oder Fehlfunktionen derartiger Komponenten führen können. Die Vorteile sind hierauf aber nicht beschränkt.

Die hinsichtlich einer Potenzialunterschreitung zu überwachenden Außenanschlusskontakte von beispielsweise Ausgangstransistoren können zusätzlich auch mit einem ESD-Schutz beschaltet sein, der integraler Bestandteil des beispielsweise Transistors oder als ein zusätzlich zum Transistor ausgebildetes Schaltungsteil realisiert sein kann. Schließlich kann der ESD-Schutz auch in Form einer Ansteuerung des Transistors ausgebildet sein, durch die der Transistor bei einem ESD-Ereignis geschaltet wird.

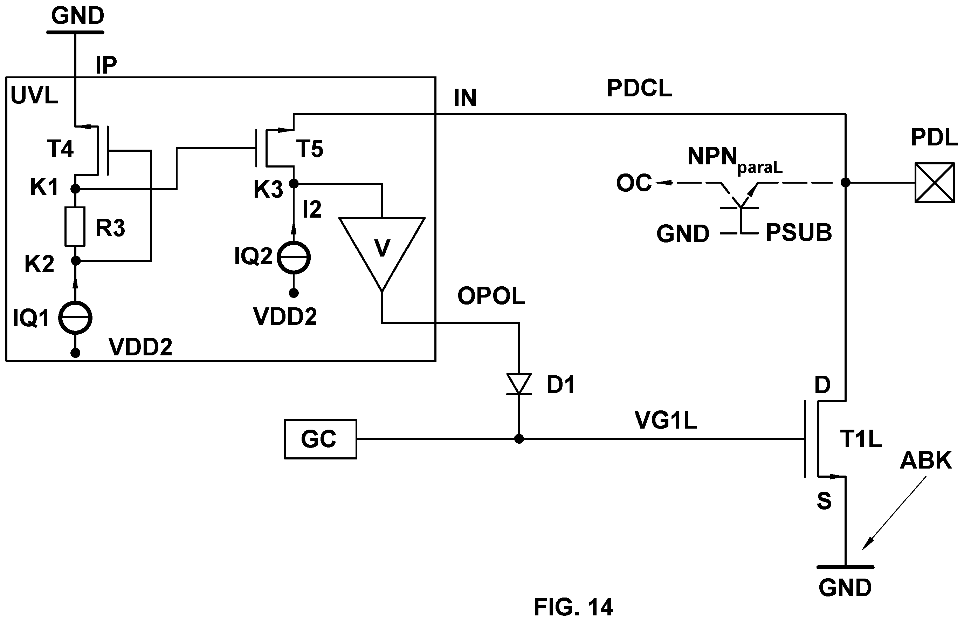

Nachfolgend werden mehrere Beispiele für Schaltkreise näher beschrieben, wobei die Fign. 14 bis 19 erfindungsgemäße sind. Im Einzelnen zeigen dabei:

| | |
|---|---|
| Fign. 1a | eine Darstellung zur Verdeutlichung der Ausbildung parasitärer Strukturen in Halbleitersubstraten mit integrierten CMOS-Schaltungen, wenn einzelne aktive Gebiete ein Potenzial unterhalb des Substratpotenzials aufweisen, |
| Fign. 1b und 1c | die Folgen von parasitären Strukturen bei High-Side- und Low-Side-Schaltern aus dem Stand der Technik, |
| Fig. 2 | eine Airbag Zündstufe entsprechend dem Stand der Technik, |
| Fig. 3 | die Grundidee der Erfindung angewendet auf die Absicherung eines High-Side-Ausgangstransistors T1H eines Airbag-Zündkreises, |
| Fig. 4 | eine Schaltung entsprechend der in Fig. 3 mit der zusätzlichen Eigenschaft, dass eine Signalisierung des Fehlerzustands erfolgt, |
| Fig. 5 | eine Schaltung entsprechend der in Fig. 4 mit dem Unterschied, dass die Signalisierung des Fehlerzustands anders als in dem Beispiel der Fig. 3 generiert wird, |
| Fig. 6 | die Grundidee der Erfindung angewendet auf die Absicherung eines Low-Side-Ausgangstransistors T1L |
| Fig. 6a | mit diesem als Schalttransistor die Grundidee der Erfindung angewendet auf die Absicherung eines Low-Side-Ausgangstransistors T1L mit einem separaten Schalttransistor T2, |
| Fig. 7 | eine Schaltung entsprechend der in Fig. 6 mit der zusätzlichen Eigenschaft, dass eine Signalisierung des Fehlerzustands erfolgt, |
| Fig. 8 | eine Schaltung entsprechend der in Fig. 7 mit alternativ ausgeführter Signalisierung des Fehlerzustands, |
| Fig. 9 | beispielhaft die Anwendung der Erfindung bei der Airbag-Zündstufe der Fig. 2, das nun erfindungsgemäß um eine erste Überwachungsschaltung UVH für den Kontakt PDH, mit dem der High-Side-Ausgangstransistor T1H innerhalb des IC verbunden ist, und eine zweite Überwachungsschaltung UVL Kontakt PDL ergänzt ist, mit dem der Low-Side-Ausgangstransistor T1L innerhalb des IC verbunden ist, |
| Fig. 10 | eine beispielhafte Realisierung der zweiten Überwachungsschaltung UVL für den Kontakt PDL, mit dem der Low-Side-Ausgangstransistor T1L verbunden ist, |
| Fig. 11 | eine beispielhafte Realisierung der ersten Überwachungsschaltung UVH für den Kontakt PDH, mit dem der High-Side-Ausgangstransistor T1H verbunden ist, |
| Fig. 12 | eine Schaltung, die weitestgehend der in Fig. 10 entspricht, wobei der Unterschied zwischen den Schaltungen der Fign. 10 und 12 dem Unterschied der Schaltungen zwischen den Fign. 6 und 7 entspricht, |
| Fig. 13 | eine Schaltung, die weitestgehend der in Fig. 11 entspricht, wobei der Unterschied zwischen den Schaltungen der Fign. 11 und 13 dem Unterschied der Schaltungen zwischen den Fign. 3 und 4 entspricht, |
| Fig. 14 | eine mögliche Realisierung der zweiten Überwachungsschaltung UVL, |
| Fig. 15 | eine mögliche Realisierung der ersten Überwachungsschaltung UVH, |
| Fig. 16 | eine weitere mögliche Realisierung der zweiten Überwachungsschaltung UVL, wobei gegenüber der zweiten Überwachungsschaltung UVL der Fig. 14 der dritte Widerstand R3 durch eine Drahtbrücke er- |

setzt ist und an IN eine Diode D2, z.B. eine Schottky-Diode angeschlossen ist,

Fig. 17    eine weitere mögliche Realisierung der zweiten Überwachungsschaltung UVL, wobei gegenüber der zweiten Überwachungsschaltung UVL der Fig. 14 der dritte Widerstand R3 durch eine Drahtbrücke ersetzt ist und an IN ein vierter Widerstand R4 angeschlossen ist,

Fig. 18    eine weitere mögliche Realisierung der zweiten Überwachungsschaltung UVL, wobei im Unterschied zu der zweiten Überwachungsschaltung UVL der Fig. 14 an IN eine Serienschaltung aus einen vierten Widerstand R4 und einer Diode D2 ersetzt ist,

Fig. 19    eine weitere mögliche Realisierung der zweiten Überwachungsschaltung UVL (aber auch geeignet als Realisierung der ersten Überwachungsschaltung UVH), wobei alternativ oder auch in Kombination mit unterschiedlichen Schwellspannungen und Stromdichten der beiden Transistoren eines Stromspiegels gearbeitet wird,

Fig. 20    eine weitere mögliche Realisierung der zweiten Überwachungsschaltung UVL (aber auch geeignet als Realisierung der ersten Überwachungsschaltung UVH) und

Fig. 21    eine weitere Ausführung der Überwachungsschaltung, bei der der Low-Side-Ausgangstransistor T2L Teil der zweiten Überwachungsschaltung UVL ist, indem seine Gate-Source-Strecke das Potenzial des Kontakts GEN_I/O erfasst.

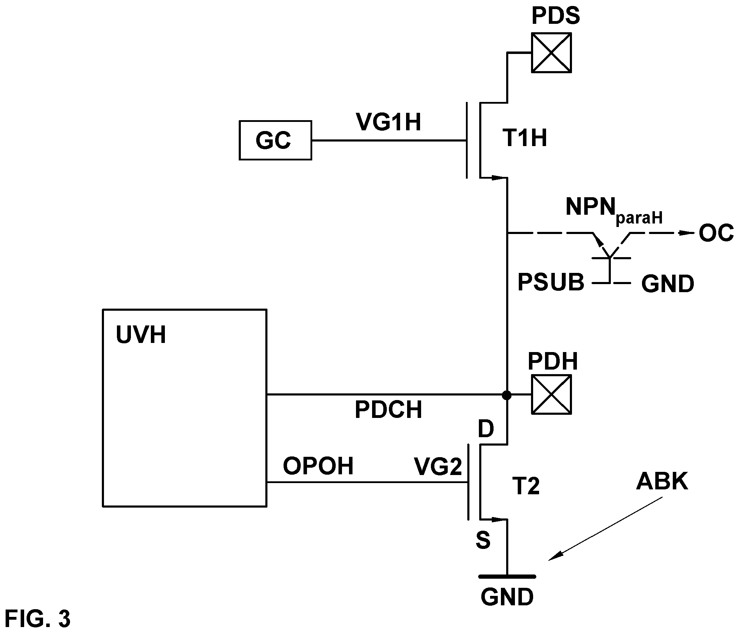

In den Fign. 3 bis 21 sind

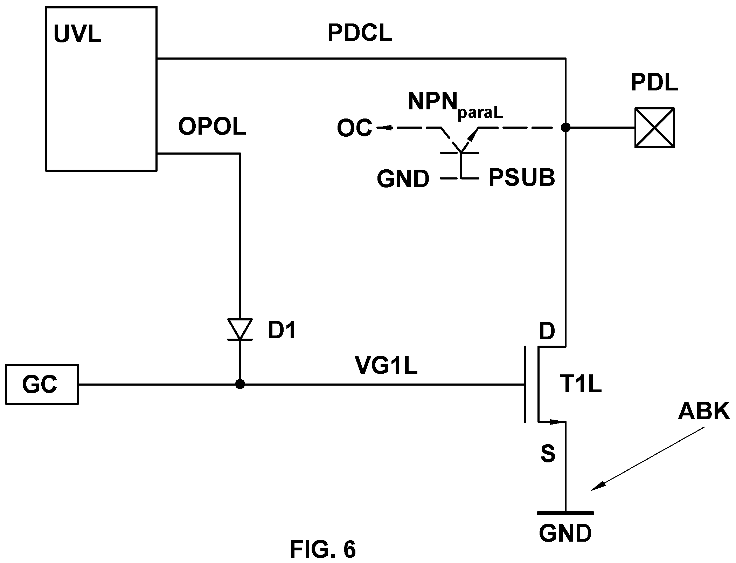

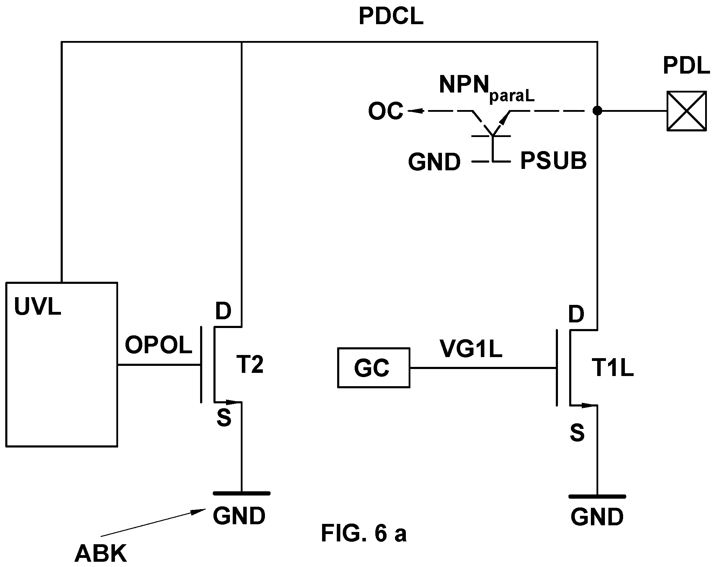

-   die grundsätzlichen Beschaltungen für die Überwachung und das Anheben des Potenzials an einem Überwachungsschaltungsknoten gezeigt (Fign. 3 bis 5 für den Fall des Anschlusses eines High-Side-Ausgangstransistors an dem Überwachungsschaltungsknoten und in den Fign. 6, 6a, 7 und 8 für den Fall, dass an dem Überwachungsschaltungsknoten ein Low-Side-Ausgangstransistor angeschlossen ist),

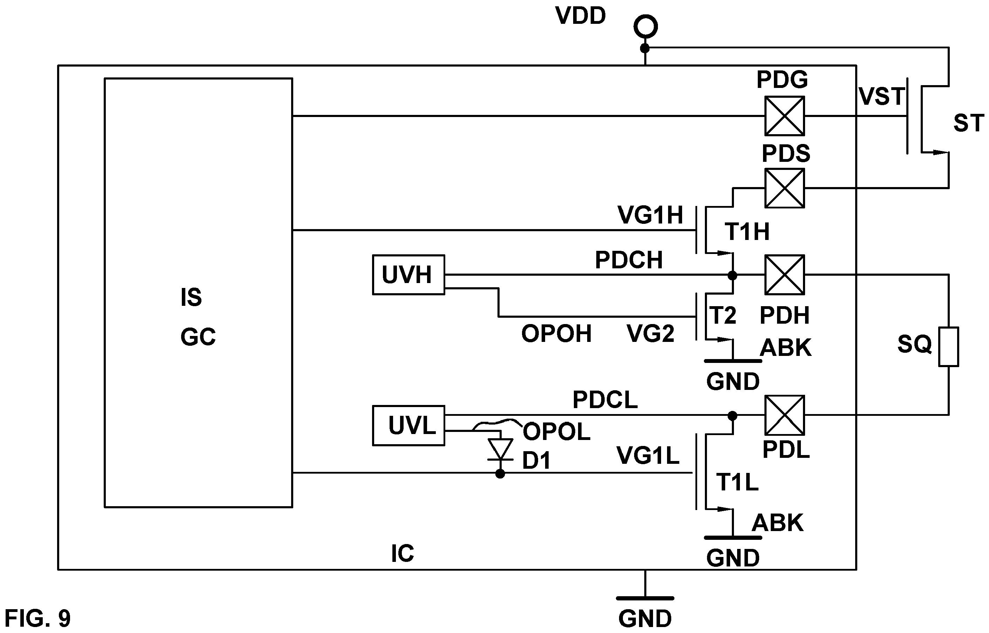

-   die Überwachung zweier Überwachungsschaltungsknoten für den Anwendungsfall einer Ausgangstreiberstufe für das Aktivierungselement eines passiven Fahrzeug-Sicherheitssystems (Fig. 9),

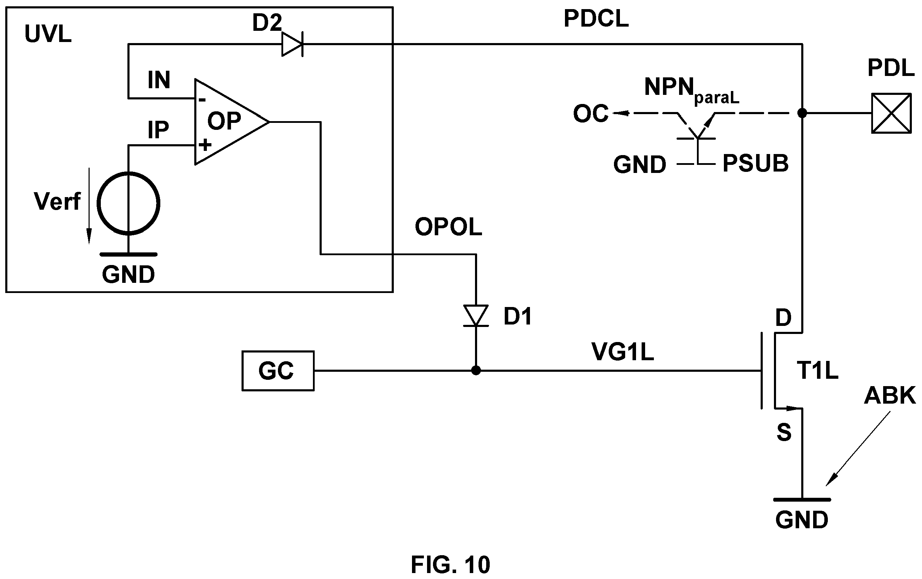

-   einzelne Ausgestaltungen für die Überwachungsschaltungen mit Vergleicherschaltung und Ansteuerung eines elektronischen Schalters (Fign. 10 bis 13),

-   Ausführungsbeispiele für die Erzeugung von Referenzspannungen bzw. Referenzpotenzialen, mit denen das Potenzial des Überwachungsschaltungsknoten zur Aktivierung einer Anhebung seines Potenzials verglichen wird (Fign. 14 bis 20), und

-   die Realisierung einer elektrischen Voreinstellung eines elektronischen Schalters, der an dem zu überwachenden Überwachungsschaltungsknoten angeschlossen ist und bei Unterschreitung des Referenzpotenzials leitet (siehe Fig. 21) gezeigt.

In den Fign. 3 bis 21 ist auch stets der Ableitschaltungsknoten ABK gekennzeichnet, wobei als ein mögliches Potenzial, auf dem dieser Knoten liegen sollte, das Bezugspotenzial GND angegeben ist. Es sei darauf hingewiesen, dass es sich hierbei um Ausführungsbeispiele handelt und weiterhin die bereits oben beschriebenen allgemeinen Eigenschaften hinsichtlich Impedanz und Potenzial des Ableitschaltungsknoten gelten, die in der bisherigen Beschreibung als vorteilhafte Ausgestaltung beschrieben sind.

Fig. 3 zeigt die Grundidee der Erfindung in ihrer Anwendung für die Absicherung eines High-Side-Ausgangstransistors T1H. Für ein besseres Verständnis sind in Fig. 3 die Schaltungsteile der Fig. 1b zusammen mit dem parasitären NPN-Transistor $NPN_{paraH}$ ebenfalls eingezeichnet. In Abwandlung zu Fig. 1b wird nun eine Überwachungsschaltung UVH für die Überwachung des Potenzials an dem mit dem High-Side-Ausgangstransistor T1H verbundenen Kontakt PHD vorgesehen, an den über eine Außenleitung z.B. die Sprengladung SQ eines Airbags angeschlossen ist. Mittels einer IC-internen High-Side-Anschlussleitung PDCH erfasst die Überwachungsschaltung UVH das Potenzial des Kontakts PDH, bei dem es sich also um den Überwachungsschaltungsknoten handelt oder der mit dem Überwachungsschaltungsknoten elektrisch verbunden ist (was auch entsprechend für die Schaltungen der weiteren Ausführungsbeispiele der Erfindung gilt), und vergleicht dieses Potenzial mit einem internen oder externen Referenzpotenzial. Hierbei können zwischen die Überwachungsschaltung UVH und die High-Side-Anschlussleitung PDCH Spannungsquellen oder funktionsähnliche Vorrichtungteile, wie beispielsweise Dioden geschaltet sein, um ein durch diese Spannungsquelle oder funktionsähnliche Vorrichtungteile erzeugtes Referenzpotenzial nutzen zu können, dessen Wert gleich oder größer ist als der Wert des Bezugspotenzials einer Bezugspotenzialleitung GND oder zumindest als der Wert des Potenzials des Substrats Sub. Ein zusätzlicher elektronischer Schalter T2 (nachfolgend mit Schalttransistor bezeichnet) wird von der Überwachungsschaltung UVH mittels einer Steuersignalleitung VG2 für die Steuerelektrode des Schalttransistors T2 durch die Überwachungsschaltung UVH gesteuert. Die Überwachungsschaltung UVH schaltet den Schalttransistor T2 typischerweise dann ein, wenn das Potenzial des Kontakts PDH unter dem Bezugspotenzial GND der Bezugspotenzialleitung GND liegt. Zumindest aber sollte die Überwachungsschaltung UVH den Schalttransistor T2 typischerweise dann einschalten, wenn das Potenzial des Kontakts PDH unter dem Potenzial PSUB des Substrats Sub liegt (was im Falle eines Fehlers erfolgen kann). In diesen Fällen liefert dann der Schalttransistor T2 den am Kontakt PDH entnommenen Strom wieder nach und zieht damit das Potenzial des Kontakts PDH wieder in Richtung des (Bezugs-)Potenzials der Bezugspotenzialleitung. Dies verhindert eine weitere Strominjektion in das Substrat und damit das Öffnen des parasitären NPN-Transistors $NPN_{paraH}$. Selbst wenn der Schalttransistor T2 nicht den gesamten entnommenen Strom kompensieren kann, so wird jedoch der Emitter-Basis-Strom des parasitären NPN-Transistors $NPN_{paraH}$ betragsmäßig gesenkt, wodurch die Auswirkungen seines Öffnens gemindert werden. In dem Fall, dass die Substratpotenzialunterschreitung am Kontakt PDH auf einen unbeabsichtigten Fehler von außen z.B. bei einem Crash erfolgt (dieser Kontakt ist nach außen geführt, da an ihn die Sprengladung SQ angeschlossen ist), wird in der Schaltung Zeit gewonnen, um noch über andere Treiberstufen weitere Airbags zünden zu können. Da zum Teil erhebliche Ströme kompensiert werden müssen, muss der Schalttransistor T2 typischerweise eine ähnliche Größe haben wie der High-Side-Ausgangstransistor T1H. Seine Betriebslebensdauer im besagten Fehlerfall ist in ähnlicher Größe wie die Betriebslebensdauer des High-Side-Ausgangstransistors T1H im ungestörten Zündbetrieb. Diese Zeit reicht aber aus, um die Zündung der anderen Zündkreise des Airbag-Systems durch die integrierte Zündvorrichtung IC zu gewährleisten, was ansonsten ohne die erfindungsgemäße Maßnahme durch die "vagabundierenden" Substratströme gegebenenfalls gestört würde.

Bei der Schaltung nach Fig. 3 sowie bei sämtlichen Schaltungen der Ausführungsbeispiele der Erfindung liegt der Ableitschaltungsknoten ABK auf dem Potenzial der Bezugspotenzialleitung GND, was aber nicht zwingend so sein muss. Entscheidend für die Wahl des Potenzials des Ableitschaltungsknotens ABK ist, dass der elektronische Schalter T2 (oder T1L) leitet, wenn das Potenzial an dem mit ihm verbundenen Überwachungsschaltungsknoten PDH, PDL gleich dem Referenzpotenzial ist oder unterhalb von diesem liegt.

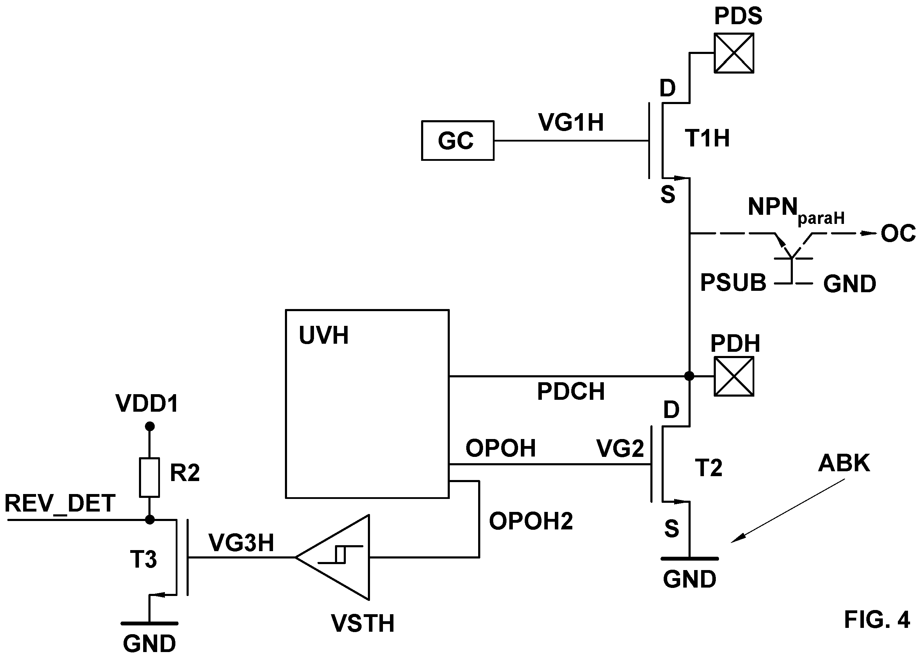

Die Fig. 4 entspricht der Fig. 3 mit dem zusätzlichen Merkmal, dass nun die Überwachungsschaltung UVH ein zweites Ausgangssignal OPO2H erzeugt, das beispielsweise aber nicht zwingend notwendig durch eine Schmitt-Triggerschaltung VSTH stabilisiert werden kann, um dann mittels eines Signalisierungstransistors T3H im Fehlerfall auf einer Signalisierungsleitung REV_DET eine Substratpotenzial- oder Bezugspotenzialunterschreitung durch z.B. eine wired-or Verknüpfung signalisieren zu können.

Dieses Signal kann gegebenenfalls noch an ein Steuergerät gegeben werden oder in einen Speicher geschrieben werden, um bei einer späteren Unfall-Analyse die Ursache eines nichtöffnenden Airbags (hier der besagte unfallverursachte Kurzschluss) nachvollziehen zu können, was in Schadensersatzfällen von Bedeutung sein kann.

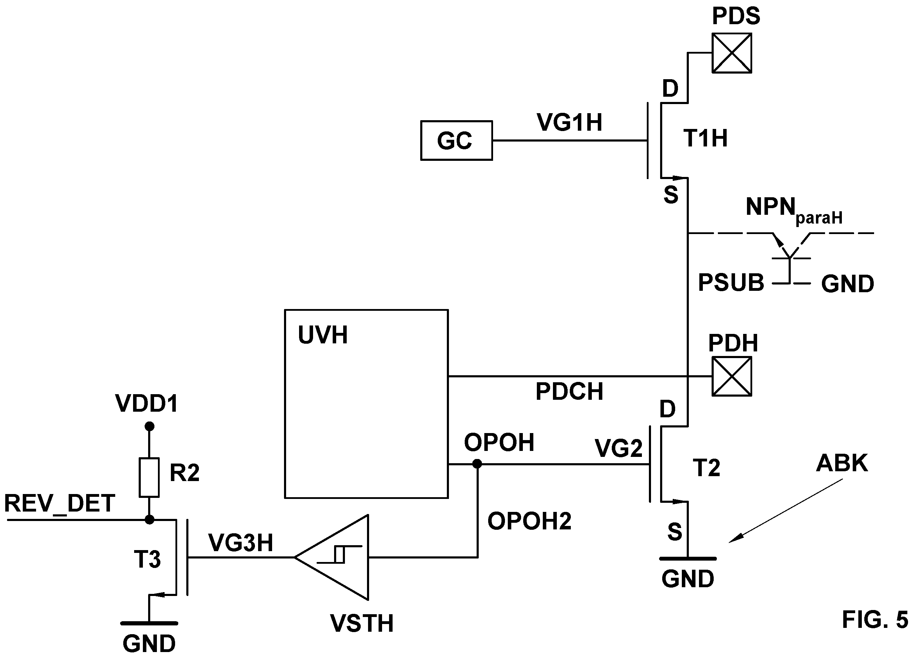

Die Fig. 5 entspricht der Fig. 4 mit dem Unterschied, dass statt eines besonderen zweiten Ausgangssignals OPO2H nun das Steuersignal auf der Steuersignalleitung VG2 für die Steuerelektrode des Schalttransistors T2 direkt für die Signalisierung des Fehlers verwendet wird.

Fig. 6 zeigt die Grundidee nun aber angewendet auf die Absicherung eines Low-Side-Ausgangstransistors T1L. Für ein besseres Verständnis sind in Fig. 6 die Schaltungsteile der Fig. 1c zusammen mit dem parasitären NPN-Transistor $NPN_{paraL}$ ebenfalls eingezeichnet. In Abwandlung zu Fig. 1c ist eine Überwachungsschaltung UVL für die Überwachung des Potenzials an dem mit dem Low-Side-Ausgangstransistor T1L verbundenen Kontakt PDL (bei dem es sich wieder um den Überwachungsschaltungsknoten oder einen mit diesem elektrisch verbundenen Knoten handelt) vorgesehen, an den z.B. die Sprengladung SQ eines Airbags angeschlossen ist. Mittels der zum Kontakt PDL führenden Anschlussleitung PDCL erfasst die Überwachungsschaltung UVL das Potenzial des Kontakts PDL und vergleicht dieses Potenzial mit einem internen oder externen Referenzpotenzial. Hierbei können zwischen die Überwachungsschaltung UVL und die Low-Side-Anschlussleitung PDCL Spannungsquellen oder funktionsähnliche Vorrichtungsteile, wie beispielsweise Dioden geschaltet sein, um wiederum ein durch diese Komponenten erzeugtes Referenzpotenzial nutzen zu können, dessen Wert gleich oder größer als der Wert des Potenzials einer Bezugspotenzialleitung GND oder zumindest als der Wert des Potenzials PSUB des Substrats Sub.

Im Gegensatz zur Schaltung nach Fig. 3 ist nun jedoch ein zusätzlicher elektronischer Schalter T2 (nachfolgend auch mit Schalttransistor bezeichnet) nicht unbedingt notwendig. Es wurde bei der Entstehung der Erfindung erkannt, dass der Low-Side-Ausgangstransistor T1L als ein solcher Schalttransistor verwendet werden kann. Somit weist in diesem Typ von Ausführungsbeispiel der Erfindung der Ableitschaltungsknoten ABK das Potenzial GND der Bezugspotenzialleitung auf. Die erste Diode D1 ermöglicht eine Einspeisung eines Stromes in die Steuersignalleitung VG1L für die Steuerelektrode des Low-Side-Ausgangstransistors T1L, wenn dieser von der Überwachungsschaltung UVL angesteuert wird. Sollte z.B. eine ESD-Schutzsteuerung ansprechen oder die für die beabsichtigte Auslösung des Airbags vorgesehene Funktionsschaltung GC den Low-Side-Ausgangstransistor T1L ansteuern, so sperrt die Diode D1 die Weiterleitung des jeweiligen, den Low-Side-Ausgangstransistor in den leitenden Zustand überführenden Ansteuersignals. Die Diode D1 ist insbesondere dann von Vorteil, wenn der Ausgang der Überwachungsschaltung UVL zu niederohmig sein sollte oder wenn die Überwachungsschaltung UVL "binäre", von Null verschiedene Signale ausgibt, nämlich ein erstes Signal mit einer ersten Größe, bei dem der Low-Side-Ausgangstransistor T1L noch nicht eingeschaltet ist, und ein zweites, typischerweise größeres Signal zum Einschalten des Low-Side-Ausgangstransistors T1L. Der von der Überwachungsschaltung UVL kommende Strom oder besser gesagt die Ausgangsspannung dieser Überwachungsschaltung UVL ist so bemessen, dass die Ausgangssignale anderer Schaltungen, nämlich die des typischerweise vorhandenen ESD-Schutzes und der Funktionsschaltung GC, überschrieben werden und der Low-Side-Ausgangstransistor T1L leitend wird und somit die Bezugspotenzialleitung GND mit dem Kontakt PDL verbindet. Somit wird der Low-Side-Ausgangstransistor T1L im Fehlerfall von der Überwachungsschaltung UVL über die Steuersignalleitung VG1L gesteuert. Die Überwachungsschaltung UVL schaltet den Low-Side-Ausgangstransistors T1L typischerweise dann ein, wenn das Potenzial des Kontakts PDL unter dem Bezugspotenzial der Bezugspotenzialleitung GND liegt. Zumindest aber sollte die Überwachungsschaltung UVL den Low-Side-Ausgangstransistors T1L dann einschalten, wenn das Potenzial des Kontakts PDL unter dem Potenzial PSUB des Substrats Sub liegt, was im Falle eines Fehlers eintreten kann. In diesen Fällen liefert der Low-Side-Ausgangstransistors T1L den am Kontakt PDL entnommenen Strom nach und zieht damit das Potenzial des Kontakts PDL wieder in Richtung des Bezugspotenzials GND der Bezugspotenzialleitung. Dies verhindert dann eine weitere Strominjektion in das Substrat und damit das Öffnen des parasitären NPN-Transistors $NPN_{paraL}$. Selbst wenn der Low-Side-Ausgangstransistors T1L nicht den gesamten entnommenen Strom kompensieren kann, so wird jedoch der Emitter-Basis-Strom des parasitären NPN-Transistors $NPN_{paraL}$ betragsmäßig gesenkt, wodurch die Auswirkungen seines Öffnens gemindert werden. In dem Fall, dass die Substratpotenzialunterschreitung am Kontakt PDH auf einen unbeabsichtigten Fehler von außen z.B. bei einem Crash erfolgt (dieser Kontakt ist nach außen geführt, da an ihn die Sprengladung SQ angeschlossen ist), wird in der Schaltung Zeit gewonnen, um noch über andere Treiberstufen weitere Airbags zünden zu können. Die Betriebslebensdauer des Low-Side-Ausgangstransistors T1L ist im Fehlerfall in ähnlicher Größe wie die des High-Side-Ausgangstransistors T1H im ungestörten Zündbetrieb. Diese Zeit reicht aber auch hier aus, um die Zündung anderer Zündkreise des Airbag-Systems, die ebenfalls Teil der CMOS-Schaltung sind, durch die Funktionsschaltung der integrierten Zündvorrichtung IC zu gewährleisten, was ansonsten ohne die erfindungsgemäße Maßnahme durch die "vagabundierenden" Substratströme gegebenenfalls gestört sein könnte.

Fig. 6a zeigt eine alternative Schaltung zum Abführen von Potenzialen am Kontakt PDL mit Werten unter Substratpotenzial, jedoch unter Verwendung eines dezidierten Schalttransistors T2, der statt des Low-Side-Ausgangstransistors T1L (wie im Beispiel der Fig. 6) von der Überwachungsschaltung UVL angesteuert wird. Hierbei kann der Ableitschaltungsknoten ABK ein vom Bezugspotenzial GND abweichendes anderes Potenzial aufweisen.

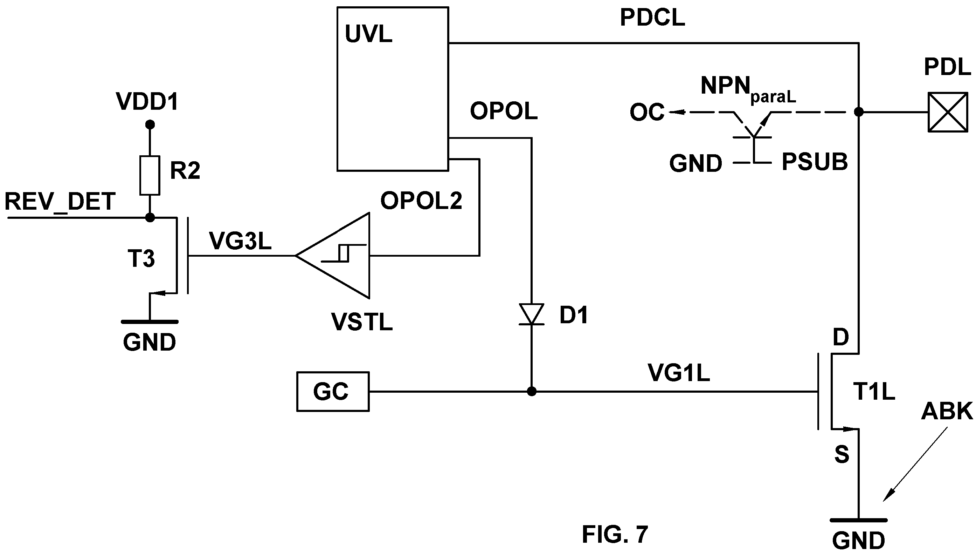

Die Schaltung der Fig. 7 entspricht derjenigen der Fig. 6 mit dem Zusatz, dass nun die Überwachungsschaltung UVL für den Kontakt PDL des Low-Side-Ausgangstransistors T1L ein zweites Ausgangssignal OPO2L erzeugt, das beispielsweise durch einen Schmitt-Trigger VSTL abgesichert werden kann, um mittels eines Signalisierungstransistors T3H im Fehlerfall über eine Signalisierungsleitung REV_DET z.B. eine Substratpotenzial- oder Bezugspotenzialunterschreitung durch eine wired-or Verknüpfung signalisieren zu können.

Dieses Signal kann gegebenenfalls noch an ein Steuergerät gegeben oder in einen Speicher geschrieben werden, um bei einer späteren Unfall-Analyse die Ursache eines nichtöffnenden Airbags (hier der besagte unfallverursachte Kurzschluss) nachvollziehen zu können, was in Schadensersatzfällen von Bedeutung sein kann.

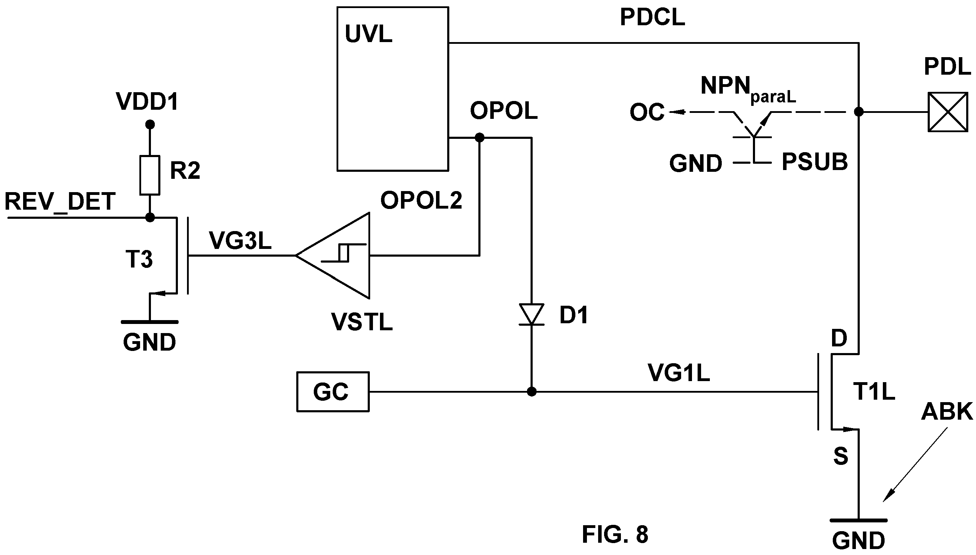

Die Schaltung der Fig. 8 entspricht derjenigen der Fig. 7 mit dem Unterschied, dass statt eines besonderen zweiten Ausgangssignals OPO2L nun das Steuersignal OPOL der Überwachungsschaltung UVL für die Ansteuerung des Low-Side-Ausgangstransistors T1L direkt für die Signalisierung des Fehlers verwendet wird.

Die Fig. 9 zeigt das beispielhafte Airbag-System der Fig. 2, das nun erfindungsgemäß um eine erste Überwachungsschaltung UVH (nach einer der Fign. 3 bis 5) für den Kontakt PDH des High-Side-Ausgangstransistors T1H und eine zweite Überwachungsschaltung UVL (nach einer der Fign. 6, 6a, 7 und 8) für den Kontakt PDL für den Low-Side-Ausgangstransistor T1L ergänzt ist. Zwischen diesen beiden Kontakten ist typischerweise eine Sprengladung SQ über unter Umständen längere im Fahrzeug verlegte Leitungen geschaltet.

Die erste Überwachungsschaltung UVH überwacht das Potenzial des Kontakts PDH des High-Side-Ausgangstransistors T1H.

Die zweite Überwachungsschaltung UVL überwacht das Potenzial des Kontakts PDL des Low-Side-Ausgangstransistors T1L.

Des Weiteren ist für die Neutralisationen eines Fehlerstromes am Kontakt PDH am High-Side-Ausgangstransistor T1H, nämlich der besagte Schalttransistor T2 vorgesehen, der den Kontakt PDH im Fehlerfall in Richtung auf das Bezugspotenzial der Bezugspotenzialleitung GND zieht. Der Schalttransistor T2 wird dabei durch die erste Überwachungsschaltung UVH gesteuert. Bezogen auf die erste Überwachungsschaltung UVH, den High-Side-Ausgangstransistor T1H und den Schalttransistor T2 entspricht die Situation also derjenigen der Schaltung der Fig. 3.

Die Neutralisation eines Fehlerstromes am Kontakt PDL am Low-Side-Ausgangstransistor T1L erfolgt über diesen Low-Side-Ausgangstransistor T1L selbst, so dass hier kein separater Schalttransistor erforderlich ist, nichtsdestotrotz aber vorgesehen sein kann (wie das Beispiel der Fig. 6a zeigt). Die zweite Überwachungsschaltung UVL schaltet den Low-Side-Ausgangstransistor T1L im Fehlerfall ein. Dann zieht der Low-Side-Ausgangstransistor T1L im Fehlerfall das Potenzial des Kontakts PDL für den Low-Side-Ausgangstransistor T1L in Richtung auf das Bezugspotenzial der Bezugspotenzialleitung GND. Bezogen auf die zweite Überwachungsschaltung UVL und den Low-Side-Ausgangstransistor T1H entspricht die Situation der Fig. 9 also derjenigen der Fig. 6.

Fig. 10 zeigt eine beispielhafte Realisierung der zweiten Überwachungsschaltung UVL für den mit dem Low-Side-Ausgangstransistor T1L verbundenen Kontakt. Ein Operationsverstärker OP erfasst mit seinem negativen Eingang IN über eine (zweite) Diode D2 das Potenzial der Low-Side-Anschlussleitung PDCL, die mit dem Kontakt PDL für den Low-Side-Ausgangstransistor T1L elektrisch verbunden ist. Der positive Eingang IP des Operationsverstärkers OP ist mit einer Referenzpotenzialquelle Vref verbunden. Sinkt das Potenzial der Low-Side-Anschlussleitung PDCL plus der Schleusenspannung der zweiten Diode D2 unter das Referenzpotenzial Vref, so schaltet der Operationsverstärker OP durch und lädt über die Diode D1 die Steuersignalleitung für die Steuerelektrode des Low-Side-Ausgangstransistors T1L so um, dass der Low-Side-Ausgangstransistor T1L durchschaltet und den Kontakt PDL mit der Bezugspotenzialleitung GND elektrisch niederohmig verbindet, so dass der Low-Side-Ausgangstransistor T1L einen großen Teil des infolge des Fehlerereignisses aus dem Kontakt PDL entnommen Stroms aus der Bezugspotenzialleitung GND nachliefern kann und so das Potenzial des Kontakts PDL zumindest für eine zur Zündung der anderen Airbags ausreichende Zeit soweit in Richtung des Bezugspotenzials der Bezugspotenzialleitung GND zieht, dass andere Zündkreise der integrierten Schaltung noch funktionstüchtig bleiben. Dabei überschreibt der Operationsverstärker OP z.B. infolge einer ausreichend starken Stromlieferfähigkeit seiner Ausgangstreiber die Ausgangssignale der Funktionsschaltung GC und einer gegebenenfalls vorhandenen ESD-Schutzschaltung.

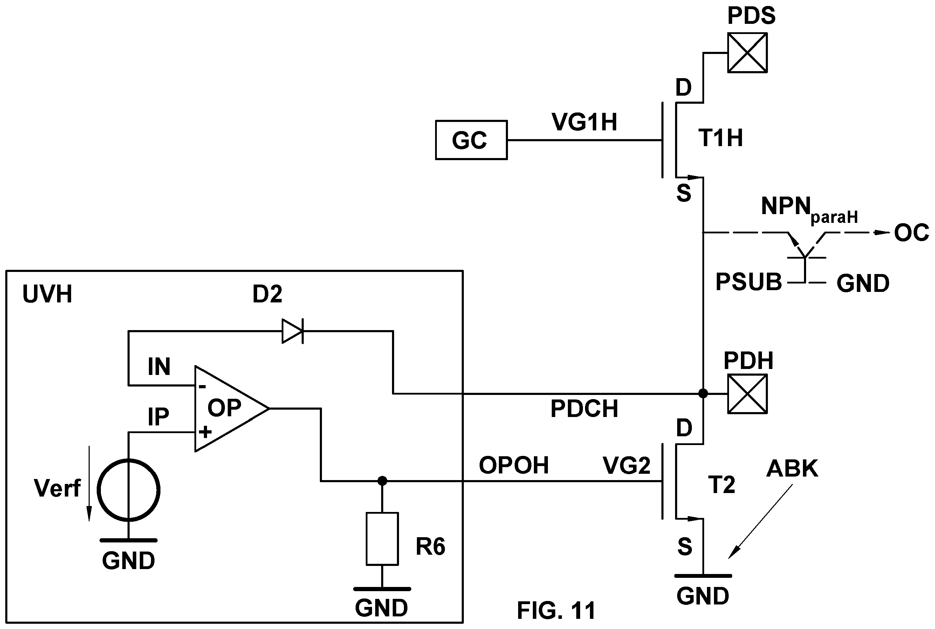

Fig. 11 zeigt eine beispielhafte Realisierung der ersten Überwachungsschaltung UVH für den Kontakt PDH für den High-Side-Ausgangstransistor T1H. Der Operationsverstärker OP erfasst mit seinem negativen Eingang IN wieder über eine (zweite) Diode D2 das Potenzial auf der internen High-Side-Anschlussleitung PDCH, die mit dem Kontakt PDH für den High-Side-Ausgangstransistor T1H elektrisch verbunden ist. Der positive Eingang IP des Operationsverstärkers OP ist mit einer Referenzpotenzialquelle Vref verbunden. Sinkt das Potenzial der High-Side-Anschlussleitung PDCH plus der Schleusenspannung der zweiten Diode D2 unter das Referenzpotenzial Vref, so schaltet der Operationsverstärker OP durch und lädt die Steuersignalleitung VG2 für die Steuerelektrode des zusätzlichen Schalttransistors T2 so um, dass der Schalttransistor T2 den Kontakt PDH mit der Bezugspotenzialleitung elektrisch niederohmig verbindet, so dass der High-Side-Ausgangstransistor T1L einen großen Teil des infolge des Fehlerereignisses aus dem Kontakt PDH entnommen Stroms aus der Bezugspotenzialleitung GND nachliefern kann und so das Potenzial des Kontakts PDH zumindest für eine zur Zündung anderer Airbags ausreichende Zeit soweit in Richtung des Bezugspotenzials der Bezugspotenzialleitung GND zieht, dass andere Zündkreise der integrierten Schaltung noch funktionstüchtig bleiben. Dabei überschreibt der Operationsverstärker OP infolge einer ausreichend starken Stromlieferfähigkeit seiner Ausgangstreiber die Ausgangssignale der Funktionsschaltung GC und einer gegebenenfalls vorhandenen ESD-Schutzschaltung und steuert den Schalttransistor T2 über VG2 an. Der Pull-Down-Widerstand R6 kann optional vorgesehen sein.

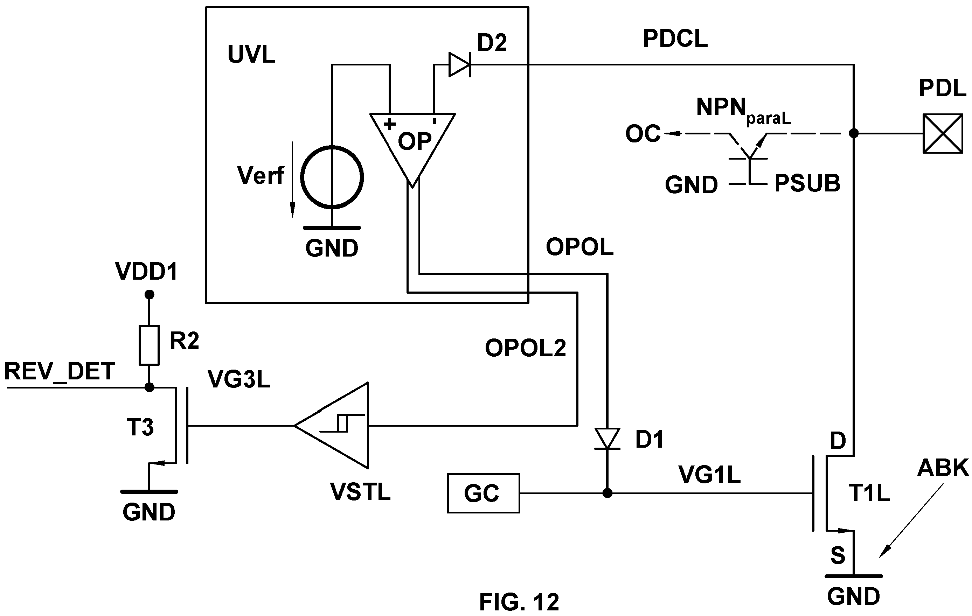

Die Schaltung der Fig. 12 entspricht weitestgehend derjenigen der Fig. 10. Der Unterschied zwischen Fig. 10 und Fig. 12 entspricht dem Unterschied zwischen den Schaltungen der Fign. 6 und 7. Auf die obige Beschreibung der Signalisierung wird verwiesen. Gemäß Fig. 12 wird der Ausgang OPOL2 des Operationsverstärkers OP (der Ausgang OPOL2 kann mit dem Ausgang OPOL identisch sein) für die Signalisierung des Umstandes verwendet, dass das Potenzial am Ausgangsanschlusskontakt PDL den Referenzwert erreicht oder unterschritten hat.

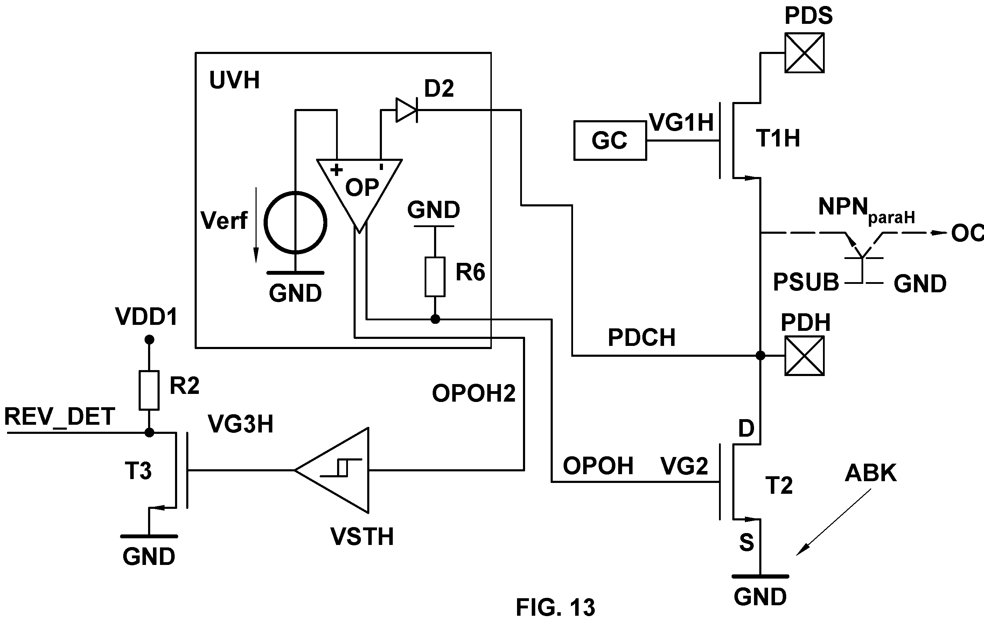

Die Schaltung der Fig. 13 entspricht weitestgehend derjenigen der Fig. 11. Der Unterschied zwischen Fig. 11 und Fig. 13 entspricht dem Unterschied zwischen den Schaltungen der Fign. 3 und 4. Auf die obige Beschreibung der Signalisierung wird verwiesen. Gemäß Fig. 13 wird der Ausgang OPOH2 des Operationsverstärkers OP (der Ausgang OPOH2 kann mit dem Ausgang OPOH identisch sein) für die Signalisierung des Umstandes verwendet, dass das Potenzial am Ausgangsanschlusskontakt PDH den Referenzwert erreicht oder unterschritten hat.

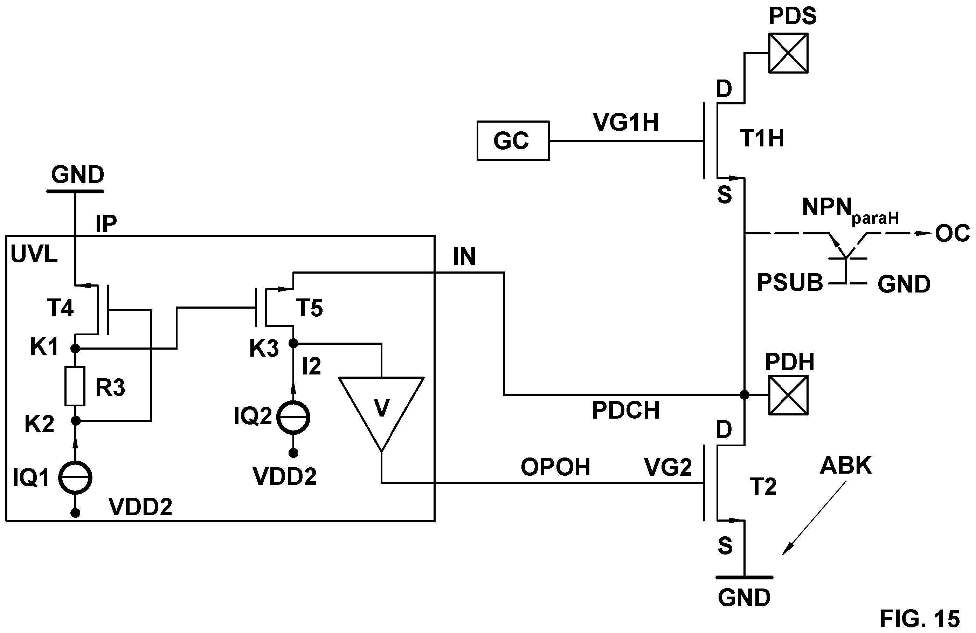

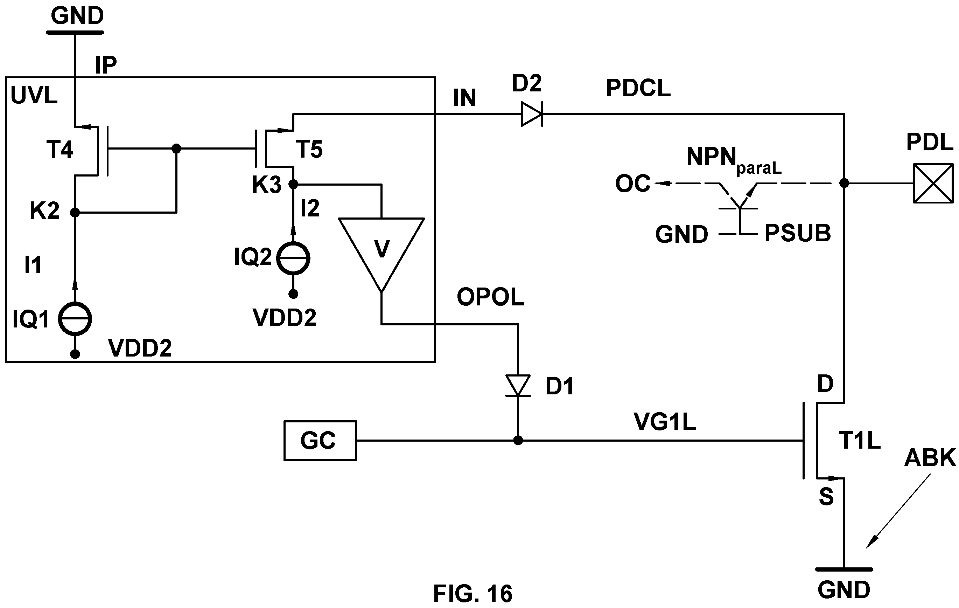

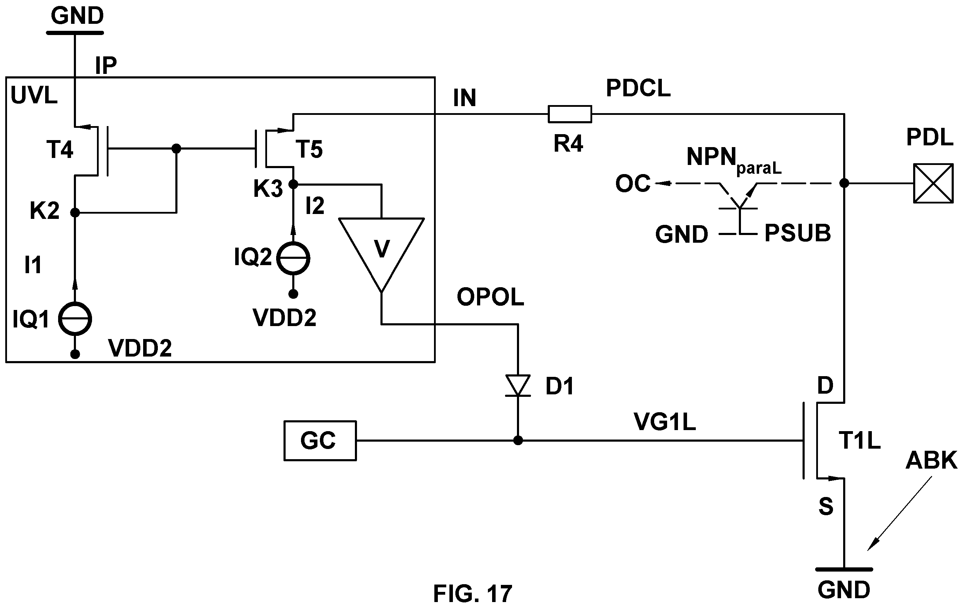

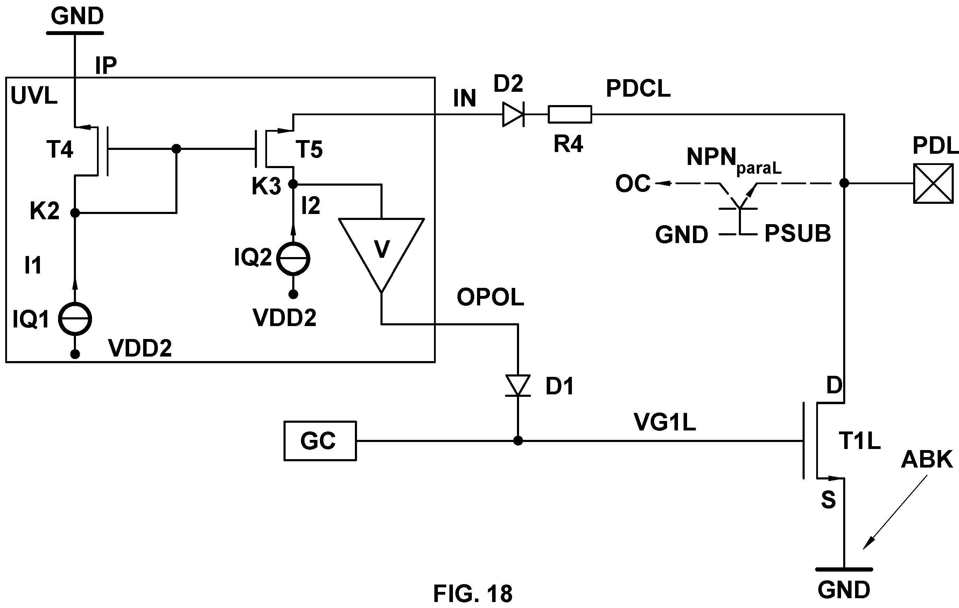

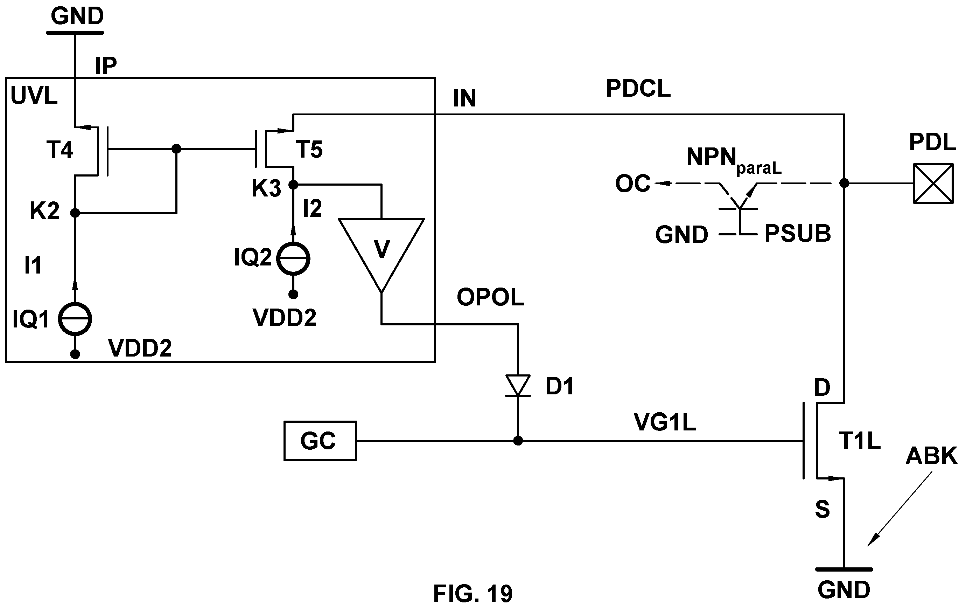

Fig. 14 zeigt eine konkrete Realisierung der zweiten Überwachungsschaltung UVL und betrifft vor allem eine erste Möglichkeit der Erzeugung des Referenzpotenzials, das unter dem des Substrats oder unter dem Bezugspotenzial liegt, welches im Regelfall Masse ist. Damit ist das Referenzpotenzial 0 oder negativ. Eine erste Stromquelle IQ1 speist einen (ersten) Strom I1 in den ersten Knoten K1 ein. Der erste Strom I1 fließt durch den (dritten) Widerstand R3 und ruft dort einen Spannungsabfall zwischen dem ersten Knoten K1 und dem zweiten Knoten K2 hervor. Der (vierte) Transistor T4 arbeitet als "verstimmte" MOS-Diode, was durch den zusätzlichen Spannungsabfall über dem Widerstand R3 hervorgerufen wird. Der (fünfte) Transistor T5 arbeitet als Stromquelle, wobei der Strom durch den Transistor T5 von seiner Gate-Source-Spannung und damit vom Potenzial an dem mit dem Low-Side-Ausgangstransistor T1L verbundenen Kontakt PDL abhängt. Der durch den Transistor T5 aus dem Knoten K3 entnommene Strom arbeitet gegen den (zweiten) Strom I2, den eine zweite Stromquelle IQ2 in einen dritten Knoten K3 einspeist. Sinkt das Potenzial des Kontakts PDL zu weit ab, so wird der Strom durch den Transistor T5 größer als der Strom I2 der zweiten Stromquelle IQ2. Das Potenzial des dritten Knotens K3 fällt dann, was dann durch einen Verstärker V mit negativer Verstärkung zu einem Potenzialanstieg des Steuersignals OPOL der zweiten Überwachungsschaltung UVL führt und damit zu einem Einschalten des Low-Side-Ausgangstransistors T1L über die Diode D1, was wiederum das Potenzial des Kontakts PDL für den Low-Side-Ausgangstransistor T1L und damit das Potenzial des dritten Knotens K3 wieder anhebt, bis ein Gleichgewicht wiederhergestellt ist. Das Potenzial am Kontakt PDL sinkt erst dann weiter, wenn die Stromlieferfähigkeit des Low-Side-Ausgangstransistors T1L durch den Fehlerstrom am Kontakt PDL überschritten wird. Diese Maßnahme kann mit denen der Schaltungen nach Fig. 16 und/oder Fig. 17 und/oder Fig. 18 und/oder Fig. 19 kombiniert werden. Diese Maßnahmen können in analoger Weise auf Abwandlungen der Schaltung der nachfolgend beschriebenen Fig. 15 angewendet werden.

Fig. 15 zeigt eine konkrete Realisierung der ersten Überwachungsschaltung UVH und betrifft vor allem eine zweite Möglichkeit der Erzeugung des Referenzpotenzials, das unter dem des Substrats oder unter dem Bezugspotenzial liegt, welches im Regelfall Masse ist. Damit ist das Referenzpotenzial 0 oder negativ. Wie leicht zu erkennen ist, unterscheidet sich die Überwachungsschaltung UVH nicht von der Ausführung der Überwachungsschaltung UVL der Fig. 14. Die (erste) Stromquelle IQ1 speist einen (ersten) Strom I1 in den (ersten) Knoten K1 ein. Der erste Strom I1 fließt durch den (dritten) Widerstand R3 und ruft dort einen Spannungsabfall zwischen dem (ersten) Knoten K1 und dem (zweiten) Knoten K2 hervor. Der (vierte) Transistor T4 arbeitet als "verstimmte" MOS-Diode, was durch den zusätzlichen Spannungsabfall über dem dritten Widerstand R3 hervorgerufen wird. Der (fünfte) Transistor T5 arbeitet als Stromquelle, wobei der Strom durch den Transistor T5 von seiner Gate-Source-Spannung und damit vom Potenzial am Kontakt PDH für den High-Side-Ausgangstransistor T1H abhängt. Der durch den Transistor T5 aus dem dritten Knoten K3 entnommene Strom arbeitet gegen den zweiten Strom I2, den eine (zweite) Stromquelle IQ2 in den Knoten K3 einspeist. Sinkt das Potenzial des mit dem High-Side-Ausgangstransistor T1H verbundenen Kontakt PDH zu weit ab, so wird der Strom durch den Transistor T5 größer als der Strom I2 der Stromquelle IQ2. Das Potenzial des Knotens K3 fällt dann, was dann durch einen Verstärker V mit negativer Verstärkung zu einem Potenzialanstieg des Steuersignals OPOH der ersten Überwachungsschaltung UVH führt und damit zu einem Einschalten des Steuertransistors T2, was wiederum das Potenzial des Kontakts PDH für den High-Side-Ausgangstransistor T1H und damit das Potenzial des Knotens K3 wieder anhebt, bis ein Gleichgewicht wiederhergestellt ist. Das Potenzial am Kontakt PDH für den High-Side-Ausgangstransistor T1H sinkt erst dann weiter, wenn die Stromlieferfähigkeit des Steuertransistors T2 durch den Fehlerstrom am Kontakt PDH für den High-Side-Ausgangstransistor T1H überschritten wird.

Die Schaltung nach Fig. 16 entspricht derjenigen der Fig. 14. Im Gegensatz zur Schaltung nach Fig. 14 entfällt der Widerstand R3. Zwischen dem negativen Ausgang IN und der Low-Side-Anschlussleitung PDCL ist die Diode D2 eingefügt, die z.B. als Bipolar-Diode oder als Schottky-Diode ausgebildet sein kann. In dem Fall beginnt der Low-Side-Ausgangstransistor T1L zu leiten, wenn das Potenzial des Kontakts PDL um den Betrag unter dem Bezugspotenzial der Bezugspotenzialleitung GND liegt, der der Schleusenspannung der zweiten Diode D2 entspricht. Diese Maßnahme kann mit denen der Schaltung nach Fig. 15 und/oder Fig. 17 und/oder Fig. 18 und/oder Fig. 19 und/oder 20 kombiniert werden. Diese Maßnahmen können in analoger Weise auf Abwandlungen der Schaltung nach Fig. 15 angewendet werden.

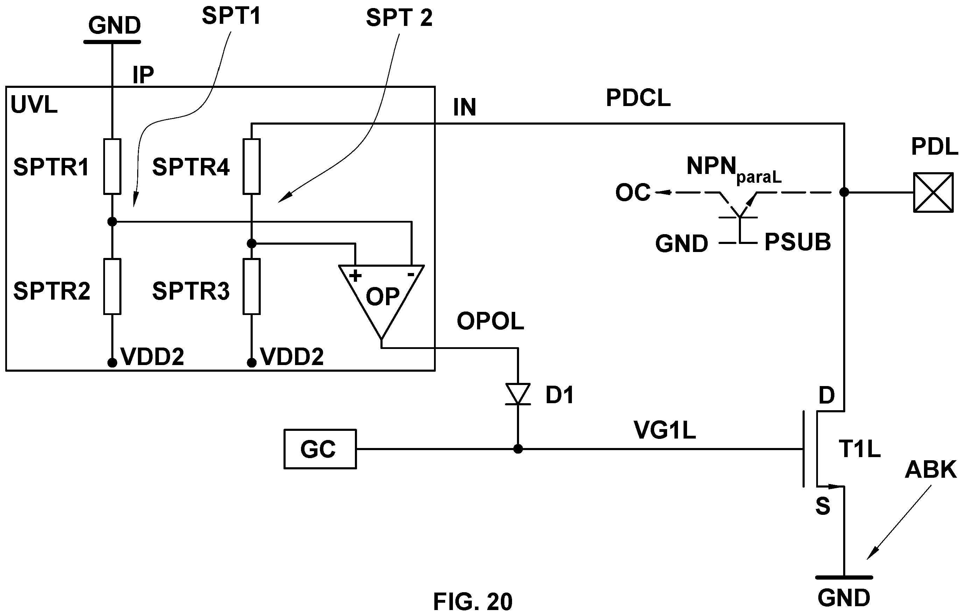

Die Schaltung nach Fig. 17 entspricht derjenigen der Fig. 14. Im Gegensatz zur Schaltung nach Fig. 14 entfällt der Widerstand R3. Zwischen dem negativen Ausgang IN und der Low-Side-Anschlussleitung PDCL ist ein (vierter) Widerstand R4 eingefügt. In dem Fall beginnt der Low-Side-Ausgangstransistor T1L zu leiten, wenn das Potenzial des Kontakts PDL um den Betrag des Produkts aus dem Betrag des zweiten Stromes I1 mal dem Wert des Widerstands R4 unter dem Bezugspotenzial der Bezugspotenzialleitung GND liegt. Diese Maßnahme kann mit denen der Schaltung nach Fig. 14 und/oder Fig. 18 und/oder Fig. 19 und/oder Fig. 20 kombiniert werden. Diese Maßnahmen können in analoger Weise auf Abwandlungen der Fig. 15 angewendet werden.

Fig. 18 zeigt eine mögliche Realisierung der zweiten Überwachungsschaltung UVL, wobei gegenüber der zweiten Überwachungsschaltung UVL der Schaltung nach Fig. 14 am negativen Ausgang IN eine Serienschaltung aus einem (vierten) Widerstand R4 und der Diode D2 vorgesehen ist.

Die Schaltung der Fig. 18 entspricht derjenigen der Fig. 14. Im Gegensatz zur Schaltung nach Fig. 14 ist zwischen den negativen Ausgang IN und den mit den der Low-Side-Ausgangstransistor T1L die Serienschaltung aus dem Widerstand R4 und der Diode D2 eingefügt. In dem Fall beginnt der Low-Side-Ausgangstransistor T1L zu leiten, wenn das Potenzial des Kontakts PDL um den Betrag des Produkts aus der Größe des zweiten Stromes I1 mal dem Wert des Widerstands R4 plus der Schleusenspannung der Diode D2 unter dem Bezugspotenzial der Bezugspotenzialleitung GND liegt. Diese Maßnahmen können in analoger Weise auf Abwandlungen der Schaltung nach Fig. 15 angewendet werden.

In den Fign. 14 bis 18 sind verschiedene Realisierungsmöglichkeiten für die Einstellung und Vorgabe der Referenzspannung gezeigt, bei deren Unterschreitung die erfindungsgemäße Maßnahme zur Verhinderung der Injektion von Substratströmen greifen. Alternativ zu beispielsweise den Fign. 14 und 15 sowie 16 und 17 können die verschiedenen Referenzspannungen auch durch Transistoren T4 und T5 mit unterschiedlichen Schwellspannungen oder mit unterschiedlichen Stromdichten, d.h. unterschiedlich großen Gate-Elektroden und dementsprechend unterschiedlich großen Kanälen realisiert werden. Auch können die Ströme I1 und I2 unterschiedlich groß sein. Insoweit sei darauf hingewiesen, dass die Erfindung nicht auf die in den zuvor genannten Figuren gezeigten Schaltungen beschränkt ist. All diese Varianten soll Fig. 19 zeigen, deren Schaltung für z.B. die Überwachungsschaltung UVL (aber gleichermaßen auch für die Überwachungsschaltung UVH) einen Stromspiegel mit den beiden Stromquellen IQ1, IQ2 und den beiden Transistoren T4, T5 aufweist, wobei mit der Verbindung der zweiten Stromquelle IQ2 mit dem Transistor T5 der Eingang des Verstärkers V, der eine negative Verstärkung aufweist, verbunden ist. Am Anschluss IP liegt das Bezugspotenzial GND an, während der Anschluss IN mit dem zu überwachenden Kontakt PDL verbunden ist. Die Anwendung dieser Schaltung nach Fig. 19 für die Realisierung der Überwachungsschaltung UVH ist identisch möglich.

Fig. 20 zeigt eine Realisierung für die Überwachungsschaltung UVL oder UVH mit einem Operationsverstärker OP mit dem Ausgang OPOH bzw. OPOL und einem negativen sowie einem positiven Eingang. An beiden Eingängen ist ein Schaltungsknoten jeweils eines anderen von zwei Spannungsteilern SPT1, SPT2 angeschlossen. Die beiden Widerstände SPTR1 und SPTR2 des Spannungsteilers SPT1 sind zwischen ein Versorgungspotenzial VDD und das Bezugspotenzial GND geschaltet, während die Widerstände SPTR3 und SPTR4 des Spannungsteilers SPT2 zwischen das Versorgungspotenzial VDD und den zu überwachenden Knoten PDH oder PDL geschaltet sind.

Fig. 21 zeigt eine weitere Ausführung der Überwachungsschaltung, bei der ein Low-Side-Ausgangstransistor T2L Teil der zweiten Überwachungsschaltung UVL ist, weil seine Gate-Source-Strecke das Potenzial des Kontakts GEN_I/O PDL erfasst.

Fig. 21 stellt eine alternative Realisierung einer Überwachungsschaltung UVL2 in Form einer Entladungsschaltung dar, die für die Überwachung einer Potenzialunterschreitung an einem im obigen Sinne kritischen Außenanschluss eines IC eingesetzt werden kann. Zur Vereinfachung ist die Ansteuerschaltung für die Steuersignalleitung VG2L für die Steuerelektrode eines Low-Side-Ausgangstransistors T2L zur Realisierung der Normalfunktion nicht eingezeichnet, damit die wesentlichen Teile der Übertragungsvorrichtung UVL2 und ihre Funktion kenntlich werden. Eine Besonderheit der Schaltung nach Fig. 21 ist, dass der Low-Side-Ausgangstransistor T2L wiederum Teil der Überwachungsschaltung UVL2 sein kann. Der Low-Side-Ausgangstransistor T2L erfasst die Potenzialdifferenz zwischen seinem Gate-Potenzial in Form des Potenzials der Steuersignalleitung VG2L für seine Steuerelektrode einerseits und dem Potenzial des Kontakts GEN_I/O andererseits. Der Low-Side-Ausgangstransistor T2L öffnet, wenn das Potenzial des Kontakts GEN_I/O unter dem Potenzial der Steuersignalleitung VG2L und dem Potenzial der Bezugspotenzialleitung GND liegt und wenn diese Potenzialdifferenz ausreichend ist, um die Schaltschwelle des Low-Side-Ausgangstransistors T2L zu überschreiten.

Wenn sich das Potenzial des Kontakts GEN_I/O unter das Bezugspotenzial der Bezugspotenzialleitung GND bewegt, wird der parasitäre NPN-Transistor $NPN_{paraL2}$ leitend. Dieses niedrige Potenzial des Kontakts GEN_I/O kann ohne Gegenmaßnahmen benachbart im Substrat angeordnete und gegebenenfalls sensitiven anderen Schaltungsteile der integrierten CMOS-Schaltung stören.

Der parasitäre NPN-Transistor $NPN_{paraL2}$ wird hier beispielhaft konkretisiert dadurch gebildet, dass der Low-Side-Ausgangstransistor T2L über eine n-Wanne verfügt, die mit dem Kontakt GEN_I/O elektrisch verbunden ist und mit dem p-dotierten Substrat Sub des CMOS-Schaltkreises einen direkten Kontakt hat. Diese n-Wanne operiert im Fehlerfall als Emitter des parasitären NPN-Transistors $NPN_{paraL2}$. Das Substrat Sub ist typischerweise p-dotiert und ist bevorzugt mit der Bezugspotenzialleitung GND verbunden oder besitzt bevorzugt ein Potenzial unterhalb des Potenzials der Bezugspotenzialleitung GND.

Der Kollektor ist eine in der Nähe des Low-Side-Anschlusstransistors T2L liegende n-Wanne eines beliebigen anderen Schaltungsteils der integrierten CMOS-Schaltung. Es kann sich z.B. um einen Transkonduktanzverstärker OTA eines Hoch-Volt-Reglers handeln, der an seinem Ausgang einen Hoch-Volt-NMOS-Transistor in einer solchen n-Wanne aufweist.

Im Falle einer ausreichend negativen Spannung am Kontakt GEN_I/O, beispielsweise in Folge eines unfallverursachten Kurzschlusses in der an diesen Kontakt angeschlossenen, im Fahrzeug verlegten Leitung würde ohne die hier dargestellte Schaltung der Ausgangsstrom dieses OTA über einen Kurzschluss zwischen der n-Wanne des Ausgangstransistors des OTA und der n-Wanne des Low-Side Ausgangstransistors T2L beeinflusst, so dass der Regler gegebenenfalls gestört wird oder ganz ausfällt.

Im oben beschriebenen Fall hat die Entladung des Kontakts GEN_I/O zwei Funktionen:

    a. das Entladen der parasitären Kapazität am Kontakt GEN_I/O und
    b. den Schutz gegen den injizierten Strom, so dass dieser nicht als Substartstrom in das Substrat Sub injiziert wird und als Basis-Emitter-Strom den parasitären Transistor $NPN_{paraL2}$ durchschaltet.

Ein wie auch immer gearteter ESD-Schutz für den Low-Side-Ausgangstransistor T2L kann vorgesehen sein.

Der (vierte) Knoten K4 ist über den (fünften) Widerstand R5 mit dem Ausgang OPOL verbunden, der den Low-Side-Ausgangstransistor T1L steuert. Das Transistorpaar aus dem (sechsten) Transistor T6 und Low-Side-Ausgangstransistor T2L arbeitet dann als Stromspiegel für den (dritten) Strom I3 der (dritten) Stromquelle IQ3, der dann den Strom durch das Squib SQ bestimmen kann, wobei nun jedoch der Knoten K4 gegenüber dem Ausgang OPOL um eine Spannung angehoben wird, die dem Produkt aus dem Wert des dritten Stromes I3 und dem Wert des fünften Widerstands R5 entspricht.

Der Stromspiegel wird auch als eine Entladeschaltung genutzt, die die Last am Kontakt GEN_I/O entlädt, also den zusätzlich injizierten Strom schon direkt an diesem Kontakt aufnimmt.

Im Normalbetrieb sollte der Low-Side-Ausgangstransistor T2L stets gesperrt sein. Hierzu muss die Spannung zwischen dem Bezugspotenzial der Bezugspotenzialleitung GND und dem Ausgang OPOL kleiner als die Schwellspannung VTH sein. Dies wird erreicht, indem die Stromquelle IQ3 den Strom I3 in den vierten Knoten K4 injiziert, von wo aus er am Widerstand R5 einen Spannungsabfall erzeugt. Die Gate-Source-Spannung $V_{G\_T2L}$ des Low-Side-Ausgangstransistors T2L zwischen Ausgangssignal OPOL2 und dem Bezugspotenzial der Bezugspotenzialleitung ist dann:

$$V_{G\_T1L}=V_{TH\_T6}-I3xR5$$

Da die Schwellspannung $V_{TH\_T6}$ ungefähr gleich der Schwellspannung $V_{TH\_T2L}$ des Low-Side-Ausgangstransistors T2L ist, ist stets sichergestellt, dass der Low-Side-Ausgangstransistor T2L gesperrt ist, wenn er im ungestörten Fall (Normalbetrieb) gesperrt sein soll.

Im Fehlerfall, wenn sich das Potenzial des Kontakts GEN_I/O unterhalb des Bezugspotenzials der Bezugspotenzialleitung GND befindet, wird jedoch der Low-Side-Ausgangstransistor T2L leitend. In dem Fall wechseln Drain-Kontakt und Source-Kontakt des Low-Side-Ausgangstransistors T2L die Rollen. Somit wird dann die Leitfähigkeit des Low-Side-Ausgangstransistors T2L von der Spannung zwischen dem Ausgang OPOL2 und dem Kontakt GEN_I/O bestimmt. Bei richtiger Wahl des Betrags des dritten Stroms I3 wird der Low-Side-Ausgangstransistor T2L dann leitend und verbindet die Bezugspotenzialleitung GND mit dem Kontakt GEN_I/O. Da er dann den an diesem Kontakt entnommenen Strom nachliefert, verhindert er die Aktivierung des parasitären NPN-Transistors $NPN_{paraL2}$.

Da der Ausgang OPOL2 vorgespannt ist, reicht eine kleine negative Spannung am Kontakt GEN_I/O gegenüber der Bezugspotenzialleitung GND aus, um den Low-Side-Ausgangstransistor T2L im dem obigen Reverse-Fall (Drain- und Source-Kontakte sind vertauscht) zu betreiben.

Dadurch wird die Aktivierung des parasitären NPN-Transistors $NPN_{paraL2}$ zuverlässig verhindert.

Für eine solche Aktivierung des parasitären NPN-Transistors $NPN_{paraL2}$ wird zwischen Substrat Sub und Kontakt GEN_I/O typischerweise eine Spannung von betragsmäßig 0,7 V benötigt. Wenn die Schaltschwelle bei -300 mV für I3xR5 liegt, dann wird der Low-Side-Ausgangstransistor T2L bei -300 mV gegenüber der Bezugspotenzialleitung GND am Kontakt GEN_I/O eingeschaltet. Die Spannung von -300 mV am Kontakt GEN_I/O gegenüber der Bezugspotenzialleitung GND reicht nicht aus, um den parasitären NPN-Transistors $NPN_{paraL2}$ zu zünden, da die Schleusenspannung der Basis-Emitter-Diode des parasitären NPN-Transistors $NPN_{paraL2}$ eine betragsmäßig höhere Spannung erfordert.

Bei der Schaltung nach Fig. 21 wird also die Steuerelektrode des Transistors T2L elektrisch derart "vorgespannt", dass dieser Transistor T2L leitet, sobald an seinem Drain-Anschluss ein Potenzial gleich dem Referenzpotenzial oder unterhalb des Referenzpotenzials anliegt. Am Source-Anschluss des Transistors T2L, der mit dem Ableitschaltungsknoten ABK elektrisch verbunden ist, liegt ein entsprechendes "passendes" Potenzial an.

Die Schaltung nach Fig. 21 kann als weitere Alternative für sowohl die Überwachungsschaltung UVH als auch die Überwachungsschaltung UVL eingesetzt werden, wobei jeweils ein dezidierter Schalttransistor T2L eingesetzt wird, der, bezogen auf z.B. eine Ausgangstreiberstufe mit High-Side-Transistor und Low-Side-Transistor, jeweils zwischen deren nach außen geführten und hinsichtlich ihrer Potenziale zu überwachenden Anschlüssen und einem gemeinsamen oder jeweils einem getrennten Ableitschaltungsknoten angeordnet wird.

## BEZUGSZEICHENLISTE

| | |
|---|---|
| ABK | Ableitschaltungsknoten |
| B | Basis |
| C1 | Kollektor |
| C2 | Kollektor |
| C3 | Kollektor |
| D1 | erste Diode |
| D2 | zweite Diode |
| E | Emitter |
| EN | Einschaltsignal |
| GC | Funktionsschaltung, die die eigentliche Funktion des CMOS-Schaltkreises reali- |

|          |                                                                 |
|----------|-----------------------------------------------------------------|
|          | siert                                                           |
| GEN_I/O  | Außenanschlusskontakt                                           |
| GND      | Bezugspotenzialleitung                                          |
| I1       | erster Strom                                                    |
| I2       | zweiter Strom                                                   |
| I3       | dritter Strom                                                   |
| IC       | integrierter CMOS-Schaltkreis                                   |
| IN       | negativer Eingang des Operationsverstärkers OP                  |
| IP       | positiver Eingang des Operationsverstärkers OP                  |
| IQ1      | erste Stromquelle                                               |
| IQ2      | zweite Stromquelle                                              |
| IQ3      | dritte Stromquelle                                              |
| IS       | interne Schaltung des integrierten Schaltkreises IC             |
| K1       | erster Knoten                                                   |
| K2       | zweiter Knoten                                                  |
| K3       | dritter Knoten                                                  |
| K4       | vierter Knoten                                                  |
| NG       | N-Gebiet                                                        |
| NG1      | N-Gebiet                                                        |
| NG2      | N-Gebiet                                                        |
| NG3      | N-Gebiet                                                        |
| NPN1     | NPN-Transistor                                                  |
| NPN2     | NPN-Transistor                                                  |
| NPN3     | NPN-Transistor                                                  |
| NPN$_{para}$  | parasitärer NPN-Transistor                                 |
| NPN$_{paraH}$ | parasitärer NPN-Transistor am mit dem High-Side-Ausgangstransistor T1H verbundenen Außenanschlusskontakt PDH |
| NPN$_{paraL}$ | parasitärer NPN-Transistor am mit dem Low-Side-Ausgangstransistor T1L verbundenen Außenanschlusskontakt PDL |
| NPN$_{paraL2}$ | parasitärer NPN-Transistor am Außenanschlusskontakt GEN_I/O für den Low-Side-Ausgangstransistor T2L |
| OFF      | Ausschaltsignal                                                 |
| OP       | Operationsverstärker                                            |
| OPOH     | Ausgang des Operationsverstärkers OP bzw. Steuersignal der ersten Überwachungsschaltung UVH |
| OPOL     | Ausgang des Operationsverstärkers OP bzw. Steuersignal der zweiten Überwachungsschaltung UVL |
| OPOL2    | Ausgang des Operationsverstärkers OP bzw. Steuersignal der zweiten Überwachungsschaltung UVL2 |
| OPO2H    | zweites Ausgangssignal zur Signalisierung einer Potenzialunterschreitung am mit dem High-Side-Ausgangstransistor T1H verbundenen Außenanschlusskontakt PDH |
| OPO2L    | zweites Ausgangssignal zur Signalisierung einer Potenzialunterschreitung am mit dem Low-Side-Ausgangstransistor T1L verbundenen Außenanschlusskontakt PDL |

|          |                                                                 |
|----------|-----------------------------------------------------------------|
| OS       | Oberseite des Substrats                                         |
| PDCH     | IC-interne High-Side-Anschlussleitung                          |
| PDCL     | IC-interne Low-Side-Anschlussleitung                           |
| PDG      | Außenanschlusskontakt des IC, mit dem die Steuerelektrode des Sicherheitstransistors ST über eine externe Leitung verbunden ist |
| PDH      | Außenanschlusskontakt (Überwachungsschaltungsknoten) des IC, mit dem der High-Side-Ausgangstransistor T1H verbunden ist und an den über eine externe Leitung eine Sprengladung (Squib) angeschlossen ist |
| PDL      | Außenanschlusskontakt (Überwachungsschaltungsknoten) des IC, mit dem der Low-Side-Ausgangstransistor T1L verbunden ist |
| PDS      | Außenanschlusskontakt des IC, an den von außen der Sicherheitstransistors ST angeschlossen ist |
| PSUB     | Substratpotential                                               |
| R1       | erster Widerstand                                               |
| R2       | zweiter Widerstand                                              |
| R3       | dritter Widerstand                                              |
| R4       | vierter Widerstand                                              |
| R5       | fünfter Widerstand                                              |
| R6       | sechster Widerstand                                             |
| REV_DET  | Signalisierungsleitung                                          |
| SPT1     | erste Spannungteiler                                            |
| SPT2     | zweiter Spannungteiler                                          |
| SPTR1    | erster Widerstand des ersten Spannungsteilers                  |
| SPTR2    | zweiter Widerstand des ersten Spannungsteilers                 |
| SPTR3    | erster Widerstand des zweiten Spannungsteilers                 |
| SPTR4    | zweiter Widerstand des zweiten Spannungsteilers                |
| SQ       | Squib (Sprengladung) eines insbesondere passiven Fahrzeuginsassenrückhaltesystems (wie z.B. Gurtstraffer) oder einer insbesondere passiven Fahrzeugsicherheitseinrichtung (wie z.B. Airbag) |
| Sub      | Substrat des CMOS-Schaltkreises                                |
| ST       | externer Sicherheitstransistor                                 |
| T1H      | High-Side-Ausgangstransistor                                   |
| T1L      | Low-Side-Ausgangstransistor                                    |
| T2L      | Low-Side-Ausgangstransistor                                    |
| T2       | Schalttransistor, der gegebenenfalls mit dem Ausgangstransistor T1L identisch sein kann |
| T3       | Signalisierungstransistor                                      |
| T3H      | Signalisierungstransistor                                      |
| T3L      | Signalisierungstransistor                                      |
| T4       | (vierter) Transistor eines Stromspiegels                       |
| T5       | (fünfter) Transistor eines Stromspiegels                       |
| T6       | (sechster) Transistor                                          |
| UVH      | erste Überwachungsschaltung für den mit                        |

| | |
|---|---|
| | dem High-Side-Ausgangstransistor T1H verbundenen Außenanschlusskontakt PDH |
| UVL | zweite Überwachungsschaltung für den mit dem Low-Side-Ausgangstransistor T1L verbundenen Außenanschlusskontakt PDL |
| UVL2 | Überwachungsschaltung |
| VDD | Versorgungspotenzial |
| VDD1 | Versorgungspotenzial |
| VDD2 | Versorgungspotenzial |
| VDD3 | Versorgungspotenzial |
| VG1H | Steuersignalleitung für die Steuerelektrode des High-Side-Ausgangstransistors T1H |
| VG1L | Steuersignalleitung für die Steuerelektrode des Low-Side-Ausgangstransistors T1L |
| VG2L | Steuersignalleitung für die Steuerelektrode des Low-Side-Ausgangstransistors T2L |
| VG2 | Steuersignalleitung für die Steuerelektrode des Schalttransistors T2 |
| VG3H | Steuersignalleitung für die Steuerelektrode des Signalisierungstransistors T3H |
| VG3L | Steuersignalleitung für die Steuerelektrode des Signalisierungstransistors T3L |
| VST | Steuersignalleitung für die Steuerelektrode des Sicherheitstransistors ST |
| VSTH | Schmitt-Trigger |
| VSTL | Schmitt-Trigger |
| Vref | Referenzspannungsquelle |

**Patentansprüche**

1. Vorrichtung zur Verwendung in einem integrierten CMOS-Schaltkreis, der ein mit Ladungsträgern eines ersten Leitungstyps dotiertes Halbleitersubstrat (Sub), insbesondere ein p-dotiertes Halbleitersubstrat (Sub) integriert ist, das aufweist

- mehrere mit Ladungsträgern eines zum ersten Leitungstyp entgegengesetzten zweiten Leitungstyps dotierte Gebiete (NG), insbesondere mehrere n-dotierte N-Gebiete (NG), die jeweils elektronische Bauteile bilden oder in denen jeweils elektronische Bauteile ausgebildet sind,
- einen Überwachungsschaltungsknoten (PDH, PDL), der in einem der dotierten Gebiete (NG) liegt oder mit einem oder mehreren der dotierten Gebiete (NG) elektrisch verbunden ist und hinsichtlich seines Potenzials zu überwachen ist,
- wobei das Halbleitersubstrat (Sub) mit einem Substratpotenzial (PSUB) beaufschlagt ist,
- wobei der CMOS-Schaltkreis ein Bezugspotenzial (GND) aufweist, und
- wobei zwischen dem dotierten Gebiet (NG) mit dem Überwachungsschaltungsknoten (PDH, PDL) und mindestens einem zu diesem dotierten Gebiet (NG) benachbarten dotierten Gebiet (NG) oder zwischen mindestens einem der dotierten Gebiete (NG), mit dem oder mit denen der Überwachungsschaltungsknoten (PDH, PDL) elektrisch verbunden ist, und einem zu diesem besagten dotierten Gebiet (NG) benachbarten dotierten Gebiet (NG) oder einem zu einem dieser dotierten Gebiete (NG) benachbarten dotierten Gebiet (NG) eine parasitäre bipolare Lateralstruktur, insbesondere eine parasitäre bipolare NPN-Lateralstruktur, ausgebildet ist,
- einen elektronischen Schalter (T2, T1L) mit einem Leitungspfad, der einerseits elektrisch mit dem Überwachungsschaltungsknoten (PDH, PDL) verbunden ist und andererseits mit einem Ableitschaltungsknoten (ABK) zum Ableiten von Strom aus dem Überwachungsschaltungsknoten (PDH, PDL) elektrisch verbunden ist, und mit einer Steuerelektrode zum Sperrend- und Leitendschalten des Leitungspfades,

**gekennzeichnet durch**

- eine Überwachungsschaltung (UVH, UVL) für den Überwachungsschaltungsknoten (PDH, PDL), die einen das Potenzial an dem Überwachungsschaltungsknoten (PDH, PDL) repräsentierenden Potenzialwert erfasst,
- wobei die Überwachungsschaltung (UVH, UVL) eine Vergleicherschaltung aufweist, die den erfassten Potenzialwert mit einem vorgegebenen Referenzpotenzial vergleicht,
- wobei das Referenzpotenzial gleich dem oder kleiner als das Substratpotenzial (PSUB) oder gleich sowohl dem Substratpotenzial (PSUB) als auch dem Bezugspotenzial (GND) oder kleiner als sowohl das Substratpotenzial (PSUB) als auch das Bezugspotenzial (GND) ist und
- wobei die Überwachungsschaltung (UVH, UVL) ein Einschaltsignal zum Leitendschalten des elektronischen Schalters (T2, T1L) direkt oder indirekt erzeugt, wenn der erfasste Potenzialwert gleich dem Referenzpotenzial ist oder unterhalb des Referenzpotenzials liegt,
- einen ersten Transistor (T4) mit einem Source-Anschluss, einem Drain-Anschluss und einer Steuerelektrode,
- einen zweiten Transistor (T5) mit einem Source-Anschluss, einem Drain-Anschluss und einer Steuerelektrode,
- eine erste Stromquelle (IQ1) für die Ausgabe eines ersten Stroms (I1) mit einem Ausgangsanschluss,
- wobei der Ausgangsanschluss der ersten Stromquelle (IQ1) mit dem Drain-Anschluss des ersten Transistors (T4) elektrisch verbunden ist, dessen Source-Anschluss mit dem Bezugspotenzial (GND) elektrisch verbunden ist,
- eine zweite Stromquelle (IQ2) für die Ausgabe eines zweiten Stroms (I2) mit einem Ausgangsanschluss, der mit dem Drain-Anschluss des zweiten Transistors (T5) elektrisch verbunden ist, dessen Source-Anschluss mit dem Überwachungsschaltungsknoten (PDH, PDL) elektrisch verbunden oder unter Zwischenschaltung eines Widerstands (R4) mit dem Überwachungsschaltungsknoten (PDH, PDL) elektrisch verbunden oder unter Zwischenschaltung einer Diode (D2), deren Anode mit dem Source-Anschluss des zweiten Transistors (T5) und deren Kathode mit dem Überwachungsschaltungsknoten (PDH, PDL) elektrisch verbunden ist, mit dem Überwachungsschaltungsknoten (PDH, PDL) elektrisch verbunden oder unter Zwischenschaltung einer Reihenschaltung aus einer Diode (D2) und einem Widerstand (R4) mit dem Überwachungsschaltungsknoten (PDH, PDL) elektrisch verbunden ist, wobei entweder die Kathode der Diode (D2) mit dem Source-Anschluss des zweiten Transistors (T5) oder die Anode der Diode (D2) mit dem Überwachungsschaltungsknoten (PDH, PDL) elektrisch verbunden ist,
- wobei der Ausgangsanschluss der ersten Stromquelle (IQ1) mit der Steuerelektrode des ersten Transistors (T4) elektrisch verbunden ist,
- wobei der Drain-Anschluss des ersten Transistors (T4) mit der Steuerelektrode des zweiten Transistors (T5) elektrisch verbunden ist, und
- einen Verstärker (V) mit negativer Verstärkung mit einem Eingang, der mit dem Ausgangsanschluss der zweiten Stromquelle (IQ2) elektrisch verbunden ist, und mit einem Ausgang (OPOL, OPOH) zur Ausgabe des Einschaltsignals für den elektronischen Schalter (T2, T1L),
- wobei der Ausgang (OPOL, OPOH) des Verstärkers (V) mit der Steuerelektrode des elektronischen Schalters (T2, T1L) elektrisch verbunden oder mit dieser unter Zwischenschaltung einer Diode (D1) elektrisch verbunden ist, die eine mit der Steuerelektrode des elektronischen Schalters (T2, T1L) elektrisch verbundene Kathode und eine mit dem Ausgang (OPOL, OPOH) des Verstärkers (V) elektrisch verbundene Anode aufweist,
- wobei die Größe des ersten Strom (I1) der ersten Stromquelle (IQ1) verschieden ist von der Größe des zweiten Stroms (I2) der zweiten Stromquelle (IQ2) und/oder die Steuerelektrode des ersten Transistors (T4) eine andere Größe als die Steuerelektrode des zweiten Transistors (T5) aufweist und/oder der erste Transistor (T4) eine Schwellspannung aufweist, deren Größe verschieden ist von derjenigen der Schwellspannung des zweiten Transistors (T5).

2. Vorrichtung nach Anspruch 1, **dadurch gekennzeichnet, dass** der Überwachungsschaltungsknoten (PDH, PDL) ein nach außen geführter oder nach außen zu führender Außenanschlusskontakt des CMOS-Schaltkreises ist oder mit einem nach außen geführten oder nach außen zu führenden Außenanschlusskontakt des CMOS-Schaltkreises elektrisch verbunden ist.

3. Vorrichtung nach Anspruch 1 oder 2, **dadurch gekennzeichnet, dass** der Überwachungsschaltungsknoten (PDH, PDL) der Ausgang eines Transistors einer Ausgangstreiberstufe des CMOS-Schaltkreises ist.

4. Vorrichtung nach Anspruch 3, **dadurch gekennzeichnet, dass** der Transistor der Ausgangstreiberstufe ein an das Bezugspotenzial (GND) angeschlossener Low-Side-Transistor (T1L) ist und dass der elektronische Schalter (T2) zwischen den Überwachungsschaltungsknoten (PDH, PDL) und den Ableitschaltungsknoten (ABK) angeordnet ist.

5. Vorrichtung nach Anspruch 3, **dadurch gekennzeichnet, dass** der Transistor der Ausgangstreiberstufe ein an das Bezugspotenzial (GND) angeschlossener Low-Side-Transistor (T1L) ist und dass der Low-Side-Transistor (T1L) den elektronischen Schalter bildet.

6. Vorrichtung nach Anspruch 3, **dadurch gekennzeichnet, dass** der Transistor der Ausgangstreiberstufe ein direkt oder indirekt mit einem Versorgungspotenzial (VDD) verbundener High-Side-Transistor (T1H) der Ausgangstreiberstufe ist und dass der elektronische Schalter (T2) zwischen dem Überwachungsschaltungsknoten (PDH, PDL) des High-Side-Transistors (T1H) und dem Ableitschaltungsknoten (ABK) angeordnet ist.

7. Vorrichtung nach einem der Ansprüche 1 bis 6, **dadurch gekennzeichnet, dass** die Überwachungsschaltung (UVH, UVL) ein Statussignal zur Signalisierung eines Leitendschaltens des elektronischen Schalters (T2, T1L).

8. Vorrichtung nach Anspruch 7, **dadurch gekennzeichnet, dass** eine Information über die Erzeugung des Statussignals temporär oder dauerhaft in einem Speicher abspeicherbar ist oder **gekennzeichnet durch** einen Speicher zur temporären oder dauerhaften Speicherung einer Information über die Erzeugung des Statussignals.

9. Vorrichtung nach einem der Ansprüche 1 bis 8, **dadurch gekennzeichnet, dass** der CMOS-Schaltkreis ein mit dem Überwachungsschaltungsknoten (PDH, PDL) elektrisch verbundenes, ansteuerbares, elektronisches Bauteil, wie z.B. einen Transistor, einen Thyristor o.dgl., und eine Ansteuerschaltung (IS, GC) zur Ansteuerung des Bauteils zwecks bestimmungsgemäßer Funktion dieses Bauteils und weiterer mit diesem Bauteil elektrisch zusammenwirkender Bauteile aufweist.

10. Vorrichtung zur Überwachung des Potenzials eines Überwachungsschaltungsknotens (PDH, PDL) eines CMOS-Schaltkreises, unter Verwendung einer Vorrichtung nach einem der vorhergehenden Ansprüche.

11. Vorrichtung nach einem der Ansprüche 1 bis 10, **dadurch gekennzeichnet, dass**
der Ableitschaltungsknoten (ABK) mit einem Potenzial beaufschlagt ist, das oberhalb des Referenzpotenzials liegt.

**Claims**

1. A device for use in an integrated CMOS circuit which integrates a semiconductor substrate (sub) doped with charge carriers of a first conductivity type, in particular a p-doped semiconductor substrate (sub), comprising
a plurality of regions (NG) doped with charge carriers of a second conductivity type opposite to the first conductivity type, in particular a plurality of n-doped N-regions (NG), which each form electronic components or in which electronic components are respectively formed,

- a monitoring circuit node (PDH, PDL) located in one of the doped regions (NG) or electrically connected to one or more of the doped regions (NG) and to be monitored with regard to its potential,
- wherein the semiconductor substrate (Sub) is subjected to a substrate potential (PSUB),
- wherein the CMOS circuit has a reference potential (GND), and
- wherein between the doped region (NG) with the monitoring circuit node (PDH, PDL) and at least one doped region (NG) adjacent to this doped region (NG) or between at least one of the doped regions (NG) to which the monitoring circuit node (PDH, PDL) is electrically connected and a doped region (NG) adjacent to said doped region (NG) or a doped region (NG) adjacent to one of said doped regions (NG), a parasitic bipolar lateral structure, in particular a parasitic bipolar NPN lateral structure, is formed,

- an electronic switch (T2, T1L) having a conduction path which is electrically connected to the monitoring circuit node (PDH, PDL) on the one hand and electrically connected to a derivation circuit node (ABK) for deriving current from the monitoring circuit node (PDH, PDL) on the other hand, and having a control electrode for switching the conduction path to a blocking and a conducting state,

**characterized by**

- a monitoring circuit (UVH, UVL) for the monitoring circuit node (PDH, PDL), which detects a potential value representing the potential at the monitoring circuit node (PDH, PDL),
- wherein the monitoring circuit (UVH, UVL) has a comparator circuit which compares the detected potential value with a predetermined reference potential,
- wherein the reference potential is equal to or less than the substrate potential (PSUB) or equal to both the substrate potential (PSUB) and the reference potential (GND) or less than both the substrate potential (PSUB) and the reference potential (GND), and
- wherein the monitoring circuit (UVH, UVL) directly or indirectly generates a switch-on signal for switching the electronic switch (T2, T1L) to a conducting state when the detected potential value is equal to the reference potential or is below the reference potential,
- a first transistor (T4) with a source terminal, a drain terminal and a control electrode,
- a second transistor (T5) with a source terminal, a drain terminal and a control electrode,
- a first current source (IQ1) for the output of a first current (I1) with an output terminal,
- wherein the output terminal of the first current source (IQ1) is electrically connected to the drain terminal of the first transistor (T4), the source terminal of which is electrically connected to the reference potential (GND),
- a second current source (IQ2) for outputting a second current (I2) having an output terminal electrically connected to the drain terminal of the second transistor (T5), the source terminal of which is electrically connected to the monitoring circuit node (PDH, PDL) or electrically connected to the monitoring circuit node (PDH, PDL) with the interposition of a resistor (R4) or with the interposition of a diode (D2), the anode of which is electrically connected to the source terminal of the second transistor (T5) and the cathode of which is electrically connected to the monitoring circuit node (PDH, PDL), is electrically connected to the monitoring circuit node (PDH, PDL) or is electrically connected to the monitoring circuit node (PDH, PDL) with the interposition of a series circuit comprising a diode (D2) and a resistor (R4), wherein either the cathode of the diode (D2) is electrically connected to the source terminal of the second transistor (T5) or the anode of the diode (D2) is electrically connected to the monitoring circuit node (PDH, PDL),

- wherein the output terminal of the first current source (IQ1) is electrically connected to the control electrode of the first transistor (T4),

- wherein the drain terminal of the first transistor (T4) is electrically connected to the control electrode of the second transistor (T5), and

- a negative gain amplifier (V) having an input electrically connected to the output terminal of the second current source (IQ2) and an output (OPOL, OPOH) for outputting the switch-on signal for the electronic switch (T2, T1L),

- wherein the output (OPOL, OPOH) of the amplifier (V) is electrically connected to the control electrode of the electronic switch (T2, T1L) or is electrically connected thereto with the interposition of a diode (D1) which has a cathode electrically connected to the control electrode of the electronic switch (T2, T1L) and an anode electrically connected to the output (OPOL, OPOH) of the amplifier (V),

- wherein the magnitude of the first current (I1) of the first current source (IQ1) is different from the magnitude of the second current (I2) of the second current source (IQ2) and/or the control electrode of the first transistor (T4) has a different magnitude than the control electrode of the second transistor (T5) and/or the first transistor (T4) has a threshold voltage, the magnitude of which is different from that of the threshold voltage of the second transistor (T5).

2. The device according to claim 1, **characterized in that** the monitoring circuit node (PDH, PDL) is an external connection contact of the CMOS circuit that is routed to the outside or is to be routed to the outside, or is electrically connected to an external connection contact of the CMOS circuit that is routed to the outside or is to be routed to the outside.

3. The device according to claim 1 or 2, **characterized in that** the monitoring circuit node (PDH, PDL) is the output of a transistor of an output driver stage of the CMOS circuit.

4. The device according to claim 3, **characterized in that** the transistor of the output driver stage is a low-side transistor (T1L) connected to the reference potential (GND) and **in that** the electronic switch (T2) is arranged between the monitoring circuit nodes (PDH, PDL) and the derivation circuit nodes (ABK).

5. The device according to claim 3, **characterized in that** the transistor of the output driver stage is a low-side transistor (T1L) connected to the reference potential (GND) and **in that** the low-side transistor (T1L) forms the electronic switch.

6. The device according to claim 3, **characterized in that** the transistor of the output driver stage is a high-side transistor (T1H) of the output driver stage which is connected directly or indirectly to a supply potential (VDD), and **in that** the electronic switch (T2) is arranged between the monitoring circuit node (PDH, PDL) of the high-side transistor (T1H) and the derivation circuit node (ABK).

7. The device according to any one of claims 1 to 6, **characterized in that** the monitoring circuit (UVH, UVL) generates a status signal for signaling a closing switching of the electronic switch (T2, T1L).

8. The device according to claim 7, **characterized in that** information about the generation of the status signal can be stored temporarily or permanently in a memory or **characterized by** a memory for the temporary or permanent storage of information about the generation of the status signal.

9. The device according to any one of claims 1 to 8, **characterized in that** the CMOS circuit has a controllable electronic component, such as a transistor, a thyristor or the like, which is electrically connected to the monitoring circuit node (PDH, PDL), and a control circuit (IS, GC) for controlling the component for the purpose of the intended function of this component and of further components interacting electrically with this component.

10. The device for monitoring the potential of a monitoring circuit node (PDH, PDL) of a CMOS circuit, using a device according to one of the preceding claims.

11. The device according to one of claims 1 to 10, **characterized in that** the derivation circuit node (ABK) is subjected to a potential which is above the reference potential.

**Revendications**

1. Dispositif destiné à être utilisé dans un circuit intégré CMOS, qui intègre un substrat semi-conducteur (Sub) dopé avec des porteurs de charge d'un premier type de conductivité, en particulier un substrat semi-conducteur (Sub) dopé p, qui présente

- plusieurs zones (NG) dopées avec des porteurs de charge d'un deuxième type de conductivité opposé au premier type de conductivité, en particulier plusieurs zones N (NG) dopées n, qui constituent chacune des composants électroniques ou dans lesquelles sont formés des composants électroniques,

- un nœud de circuit de surveillance (PDH, PDL) qui se trouve dans l'une des zones dopées (NG) ou qui est relié électriquement à une ou plusieurs des zones dopées (NG) et dont le potentiel doit être surveillé,

dans lequel

- le substrat semi-conducteur (Sub) est soumis à un potentiel de substrat (PSUB),
- le circuit CMOS présente un potentiel de référence (GND), et
- une structure latérale bipolaire parasite, en particulier une structure latérale bipolaire NPN parasite, est formée entre la zone dopée (NG) comportant le nœud de circuit de surveillance (PDH, PDL) et au moins une zone dopée (NG) voisine de cette zone dopée (NG), ou entre l'une au moins des zones dopées (NG) à laquelle ou auxquelles le nœud de circuit de surveillance (PDH, PDL) est relié électriquement, et une zone dopée (NG) voisine de cette zone dopée (NG), ou une zone dopée (NG) voisine de l'une de ces zones dopées (NG),
- un commutateur électronique (T2, T1L) comprenant un chemin de conduction qui est relié électriquement d'une part au nœud de circuit de surveillance (PDH, PDL) et d'autre part à un nœud de circuit de dérivation (ABK) pour dériver le courant du nœud de circuit de surveillance (PDH, PDL), et comprenant une électrode de commande pour commuter le chemin de conduction en mode bloquant et en mode conducteur,

**caractérisé par**

- un circuit de surveillance (UVH, UVL) pour le nœud de circuit de surveillance (PDH, PDL), qui détecte une valeur de potentiel représentant le potentiel au niveau du nœud de circuit de surveillance (PDH, PDL),
- le circuit de surveillance (UVH, UVL) comportant un circuit comparateur qui compare la valeur de potentiel détectée à un potentiel de référence prédéfini,
- le potentiel de référence étant égal ou inférieur au potentiel de substrat (PSUB) ou égal à la fois au potentiel de substrat (PSUB) et au potentiel de référence (GND) ou inférieur à la fois au potentiel de substrat (PSUB) et au potentiel de référence (GND), et

- le circuit de surveillance (UVH, UVL) générant directement ou indirectement un signal d'activation pour commuter le commutateur électronique (T2, T1L) en mode conducteur lorsque la valeur de potentiel détectée est égale au potentiel de référence ou inférieure au potentiel de référence,
- un premier transistor (T4) ayant une borne de source, une borne de drain et une électrode de commande,
- un deuxième transistor (T5) ayant une borne de source, une borne de drain et une électrode de commande,
- une première source de courant (IQ1) destinée à délivrer un premier courant (11) et ayant une borne de sortie,
- la borne de sortie de la première source de courant (IQ1) étant reliée électriquement à la borne de drain du premier transistor (T4), dont la borne de source est reliée électriquement au potentiel de référence (GND),
- une deuxième source de courant (IQ2) destinée à délivrer un deuxième courant (I2) et ayant une borne de sortie qui est reliée électriquement à la borne de drain du deuxième transistor (T5), dont la borne de source est reliée électriquement au nœud de circuit de surveillance (PDH, PDL) ou est reliée électriquement au nœud de circuit de surveillance (PDH, PDL) avec interposition d'une résistance (R4) ou avec interposition d'une diode (D2), dont l'anode est reliée électriquement à la borne de source du deuxième transistor (T5) et dont la cathode est reliée électriquement au nœud de circuit de surveillance (PDH, PDL), ou est reliée électriquement au nœud de circuit de surveillance (PDH, PDL) avec interposition d'un montage en série constitué d'une diode (D2) et d'une résistance (R4), sachant que soit la cathode de la diode (D2) est reliée électriquement à la borne de source du deuxième transistor (T5), soit l'anode de la diode (D2) est reliée électriquement au nœud de circuit de surveillance (PDH, PDL),
- la borne de sortie de la première source de courant (IQ1) étant reliée électriquement à l'électrode de commande du premier transistor (T4),
- la borne de drain du premier transistor (T4) étant reliée électriquement à l'électrode de commande du deuxième transistor (T5), et
- un amplificateur (V) à gain négatif, ayant une entrée reliée électriquement à la borne de sortie de la deuxième source de courant (IQ2), et ayant une sortie (OPOL, OPOH) destinée à émettre le signal d'activation pour le commutateur électronique (T2, T1L),
- la sortie (OPOL, OPOH) de l'amplificateur (V) étant reliée électriquement à l'électrode de commande du commutateur électronique (T2, T1L) ou étant reliée électriquement à celle-ci avec interposition d'une diode (D1) qui présente une cathode, reliée électriquement à l'électrode de commande du commutateur électronique (T2, T1L), et une anode, reliée électriquement à la sortie (OPOL, OPOH) de l'amplificateur (V), - la grandeur du premier courant (I1) de la première source de courant (IQ1) étant différente de la grandeur du deuxième courant (I2) de la deuxième source de courant (IQ2), et/ou l'électrode de commande du premier transistor (T4) présente une autre grandeur que l'électrode de commande du deuxième transistor (T5), et/ou le premier transistor (T4) présente une tension de seuil dont la grandeur est différente de celle de la tension de seuil du deuxième transistor (T5).

2. Dispositif selon la revendication 1, **caractérisé en ce que** le nœud de circuit de surveillance (PDH, PDL) est un contact de connexion externe du circuit CMOS, mené vers l'extérieur ou à mener vers l'extérieur, ou est relié électriquement à un contact de connexion externe du circuit CMOS, mené vers l'extérieur ou à mener vers l'extérieur.

3. Dispositif selon la revendication 1 ou 2, **caractérisé en ce que** le nœud de circuit de surveillance (PDH, PDL) est la sortie d'un transistor d'un étage d'attaque de sortie du circuit CMOS.

4. Dispositif selon la revendication 3,

   **caractérisé en ce que** le transistor de l'étage d'attaque de sortie est un transistor côté bas (T1L) connecté au potentiel de référence (GND), et
   **en ce que** le commutateur électronique (T2) est disposé entre les nœuds de circuit de surveillance (PDH, PDL) et les nœuds de circuit de dérivation (ABK).

5. Dispositif selon la revendication 3,

   **caractérisé en ce que** le transistor de l'étage d'attaque de sortie est un transistor côté bas (T1L) connecté au potentiel de référence (GND), et
   **en ce que** le transistor côté bas (T1L) constitue le commutateur électronique.

6. Dispositif selon la revendication 3,

   **caractérisé en ce que** le transistor de l'étage d'attaque de sortie est un transistor côté haut (T1H) de l'étage d'attaque de sortie, connecté directement ou indirectement à un potentiel d'alimentation (VDD), et
**en ce que** le commutateur électronique (T2) est disposé entre le nœud de circuit de surveillance (PDH, PDL) du transistor côté haut (T1H) et le nœud de circuit de dérivation (ABK).

7. Dispositif selon l'une des revendications 1 à 6, **caractérisé en ce que** le circuit de surveillance (UVH, UVL) émet un signal d'état pour signaler que le commutateur électronique (T2, T1L) est commuté en mode conducteur.

8. Dispositif selon la revendication 7, **caractérisé en ce qu'**une information relative à la génération du signal d'état peut être enregistrée de manière temporaire ou permanente dans une mémoire, ou **caractérisé par** une mémoire pour l'enregistrement temporaire ou permanent d'une information relative à la génération du signal d'état.

9. Dispositif selon l'une des revendications 1 à 8, **caractérisé en ce que** le circuit CMOS comprend un composant électronique commandable, relié électriquement au nœud de circuit de surveillance (PDH, PDL), tel qu'un transistor, un thyristor ou similaire, et un circuit de commande (IS, GC) pour commander le composant afin d'assurer le fonctionnement conforme de ce composant et d'autres composants coopérant électriquement avec ce composant.

10. Dispositif pour surveiller le potentiel d'un nœud de circuit de surveillance (PDH, PDL) d'un circuit CMOS en utilisant un dispositif selon l'une des revendications précédentes.

11. Dispositif selon l'une des revendications 1 à 10, **caractérisé en ce que** le nœud de circuit de dérivation (ABK) est soumis à un potentiel supérieur au potentiel de référence.

**FIG. 1 a**

OS E T1H NG B C1 NG1 C2 NG2 NG3 C3 NG4

PSUB PDC/L VG1/L GND

P+ N+ N+ P+ P+ N+ P+ N+ N+ P+ N+

N N N

NG1 NG2 NG3

Substrat Sub

EP 4 236 072 B1

26

PDCL

PDS

VG1H

D

T1H

GC

S

NPN$_{paraH}$

OC

Sub

GND

PDCH

PDCL

**FIG. 1 b**

PDL

PDCL

NPN$_{paraL}$

OC

Sub

GND

D

VG1L

T1L

GC

S

GND

**FIG. 1 c**

EP 4 236 072 B1

FIG. 2

PDS

GC — VG1H — T1H

NPN$_{paraH}$ → OC

PSUB — GND

UVH

PDCH

PDH

OPOH — VG2 — T2

D

ABK

S

GND

FIG. 3

PDS

T1H

VG1H

GC

D S

NPN$_{paraH}$

OC

PSUB — GND

PDH

PDCH

UVH

OPOH

VG2

T2

D S

ABK

GND

OPOH2

VSTH

VG3H

R2

VDD1

T3

GND

REV_DET

FIG. 4

FIG. 5

FIG. 6

EP 4 236 072 B1

**PDCL**

**PDL**

**NPN$_{paraL}$**

OC

**GND** ── **PSUB**

**UVL**

**OPOL**

**D**

**T2**

**S**

**GC**

**VG1L**

**D**

**T1L**

**S**

**GND**

**ABK**

**GND**

FIG. 6 a

FIG. 7

FIG. 8

FIG. 9

EP 4 236 072 B1

FIG. 10

FIG. 11

FIG. 12

EP 4 236 072 B1

FIG. 13

FIG. 14

PDL · PDCL · IN · NPN$_{paraL}$ · OC · GND · PSUB · OPOL · D1 · GC · VG1L · T1L · D · S · ABK · GND

UVL · GND · IP · T4 · K1 · R3 · K2 · IQ1 · VDD2 · T5 · K3 · I2 · IQ2 · VDD2

FIG. 15

EP 4 236 072 B1

FIG. 16

FIG. 17

**FIG. 18**

EP 4 236 072 B1

FIG. 19

**FIG. 20**

EP 4 236 072 B1

**FIG. 21**

EP 4 236 072 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 4432301 A
- DE 602004006973 T
- DE 102005048239 B
- US 20120176161 A
- US 20050110111 A